# EUROPÄISCHE PATENTSCHRIFT

(11) **EP 3 884 741 B1**
(45) Veröffentlichungstag und Bekanntmachung des Hinweises auf die Patenterteilung: **04.10.2023**
(21) Anmeldenummer: 19829174.2
(22) Anmeldetag: 19.12.2019
(51) Int. Cl.: H05K 7/14

(54) **SCHALTSCHRANKSYSTEM AUS BASISMODUL UND FUNKTIONSMODULEN SOWIE FUNKTIONSMODUL**
SWITCHING CABINET SYSTEM CONSISTING OF A BASE MODULE AND FUNCTIONAL MODULES, AND FUNCTIONAL MODULE
SYSTÈME D'ARMOIRE DE DISTRIBUTION COMPRENANT UN MODULE DE BASE ET DES MODULES FONCTIONNELS AINSI QUE MODULE FONCTIONNEL

(30) Priorität: 28.12.2018 DE 102018133647
(43) Veröffentlichungstag der Anmeldung: 29.09.2021
(73) Patentinhaber: Beckhoff Automation GmbH, 33415 Verl (DE)
(72) Erfinder: BECKHOFF, Hans, 33415 Verl (DE)
(74) Vertreter: Patentanwaltskanzlei WILHELM & BECK
(86) Internationale Anmeldenummer: PCT/EP2019/086359
(87) Internationale Veröffentlichungsnummer: WO 2020/136084

(56) Entgegenhaltungen:
- EP-A1- 0 661 915
- EP-A2- 0 236 711
- EP-A2- 2 793 540
- EP-A2- 3 018 983
- WO-A1-2004/057937
- WO-A1-2015/063292
- DE-A1-102011 110 184
- DE-A1-102012 213 281
- US-A1- 2004 201 972

## Beschreibung

Die Erfindung betrifft ein Schaltschranksystem aus einem Basismodul und mehreren Funktionsmodulen sowie ein Funktionsmodul sowie ein Basismodul für ein solches Schaltschranksystem.

Diese Patentanmeldung nimmt die Priorität der deutschen Patentanmeldung 10 2018 133 647.0 vom 28.12.2018 in Anspruch.

In modular aufgebauten Feldbussystemen, die beispielsweise in Automatisierungssystemen zum Einsatz kommen können, können Funktionsmodule direkt miteinander verbunden oder über ein Basismodul miteinander verbunden werden. Dabei kann ein Feldbus bereitgestellt werden, der von einem zum nächsten Funktionsmodul weitergegeben beziehungsweise weitergeleitet wird. Über den Feldbus kann zusätzlich eine Spannungsversorgung mit einer Kleinspannung bereitgestellt werden. Ein solches Feldbussystem ist in der Druckschrift DE 100 06 879 A1 offenbart.

Druckschrift DE 10 2011 110 184 A1 offenbart eine modulare Steuervorrichtung, bei dem mehrere zweite Modulteile ein Basismodul bilden und bei dem mehrere erste Modulteile in das Basismodul einsteckbar sind.

Druckschrift EP 0 661 915 A1 offenbart eine modulare Steuervorrichtung.

Druckschrift DE 10 2012 213 281 A1 offenbart ein Feldbusbaukastensystem mit unterschiedlichen Steckkontakten.

Druckschrift US 2004 / 0 201 972 A1 offenbart ein Feldbussystem, das ebenfalls unterschiedliche Steckkontakte aufweist.

Nachteilig an diesem Feldbussystem ist also, dass für Funktionsmodule wie beispielsweise eine Motorsteuerung, für die eine höhere Spannung notwendig ist, ein eigener Netzanschluss bereitgestellt werden muss. Dadurch ist die Verkabelung und Installation eines solchen Feldbussystems kompliziert, wenn durch das Feldbussystem die Funktionalität eines Schaltschranks bereitgestellt werden soll. Ein Schaltschrank kann dabei die elektrischen und elektronischen Komponenten einer verfahrenstechnischen Anlage (http://de.wikipe-dia.org/wiki/Verfahrenstechnik), einer Werkzeugmaschine (http://de.wikipedia.org/wiki/Werkzeugmaschine) oder Fertigungseinrichtung beinhalten, die sich nicht direkt in der Maschine befinden (siehe http://de.wikipedia.org/wiki/Schaltschrank) .

Eine Aufgabe der vorliegenden Erfindung ist es, ein Schaltschranksystem aus einem Basismodul und Funktionsmodulen sowie ein Funktionsmodul beziehungsweise ein Basismodul bereitzustellen, bei dem über das Basismodul Niederspannungen bereitgestellt werden können.

Diese Aufgaben werden durch das Schaltschranksystem, das Funktionsmodul und das Basismodul der unabhängigen Patentansprüche gelöst. Weiterbildungen sind in den abhängigen Ansprüchen angegeben.

Ein Schaltschranksystem weist ein Basismodul und mehrere Funktionsmodule auf. Das Basismodul weist ein Gehäuse mit einer Gehäuseseite und Öffnungen der Gehäuseseite, erste Anschlusselemente und zweite Anschlusselemente auf. Die ersten Anschlusselemente stellen Datenanschlüsse und Kleinspannungsanschlüsse bereit, während die zweiten Anschlusselemente Niederspannungsanschlüsse bereitstellen. Die ersten Anschlusselemente sind innerhalb des Gehäuses im Bereich von Öffnungen angeordnet, wobei die Datenanschlüsse mit einer Datenleitung verbunden sind und die Kleinspannungsanschlüsse mit einer Kleinspannungsleitung verbunden sind. Die die Niederspannungsanschlüsse der zweiten Anschlusselemente sind mit einer Niederspannungsleitung verbunden. Die Funktionsmodule weisen jeweils ein Modulgehäuse, eine elektronische Schaltung und einem Modulanschlusselement auf. Das Modulanschlusselement ist mit der elektronischen Schaltung verbunden. Das Modulgehäuse weist eine Modulgehäuseseite auf, wobei die Modulgehäuseseite eine Modulgehäuseöffnung aufweist. Das Modulanschlusselement umfasst ein erstes Steckelement, wobei sich das erste Steckelement durch die Modulgehäuseöffnung vom Inneren des Modulgehäuses zum Äußeren des Modulgehäuses erstreckt und eingerichtet ist, in die ersten Anschlusselemente des Basismoduls einzugreifen. Dadurch wird ein Schaltschranksystem bereitgestellt, mit dem mittels des Basismoduls Daten, Kleinspannung und Niederspannung bereitgestellt werden kann.

Das erste Steckelement ist zumindest in einen ersten Bereich und einen zweiten Bereich unterteilt. Erste Steckkontakte zum Übertragen von Daten sind im ersten Bereich angeordnet. Zweite Steckkontakte zum Übertragen von Kleinspannung sind im zweiten Bereich angeordnet. Das erste Anschlusselement ist in zumindest einen dritten Bereich und einen vierten Bereich unterteilt, wobei im dritten Bereich dritte Stecckontakte zum Übertragen von Daten und im vierten Bereich vierte Steckkontakte zum Übertragen von Kleinspannung angeordnet sind, wobei die ersten Steckkontakte mit den dritten Steckkontakten verbunden werden können und die zweiten Steckkontakte mit den vierten Steckkontakten verbunden werden können. Dadurch kann eine vorteilhaft aufgebaute Geometrie des ersten Steckelements beziehungsweise des ersten Anschlusselements erreicht werden, wobei die ersten Steckkontakte und die zweiten Steckkontakte unterschiedlich ausgestaltet sein können.

Bei mindestens einem Funktionsmodul umfasst das Modulanschlusselement ein zweites Steckelement, wobei das zweite Steckelement eingerichtet ist, in die zweiten Anschlusselemente des Basismoduls einzugreifen. Dadurch steht dem mindestens einen Funktionsmodul Niederspannung zur Verfügung. Die ersten Steckkontakte und die zweiten Steckkontakte sind unterschiedlich ausgestaltet. Die ersten Anschlusselemente und die zweiten Anschlusselemente sind beabstandet voneinander angeordnet.

Über die Datenanschlüsse kann ein Feldbus bereitgestellt werden, der der Kommunikation zwischen dem Basismodul und den Funktionsmodulen dienen kann. Der Feldbus kann dabei als ein in der Norm IEC 61158 definierter Feldbus, insbesondere als EtherCAT oder EtherCAT P, ausgestaltet sein.

Kleinspannungen sind dabei elektrische Spannungen bis zu 50 Volt Wechselspannung und/oder 120 Volt Gleichspannung, insbesondere bis zu 25 Volt Wechselspannung und/oder 60 Volt Gleichspannung. Diese Definition einer Kleinspannung kann der Norm IEC60449 entnommen werden. Niederspannungen sind dabei elektrische Spannungen oberhalb der Kleinspannung und bis zu 1000 Volt Wechselspannung und/oder 1500 Volt Gleichspannung. Ferner kann vorgesehen sein, eine Versorgungsspannung für Kommunikationselektronik mittels der Datenleitung bereitzustellen. Diese Versorgungsspannung kann im Bereich einiger Volt liegen.

Eine maximale Stromstärke, die über die Kleinspannungsanschlüsse bereitgestellt werden kann, kann 40 Ampere betragen. Eine maximale Stromstärke, die über die Niederspannungsanschlüsse bereitgestellt werden kann, kann 75 Ampere betragen. Es können auch größere maximale Stromstärken vorgesehen sein.

Dadurch, dass das Modulgehäuse durch die Modulgehäuseöffnung zugänglich ist, kann das Funktionsmodul mittels eines Eingriffs durch die Modulgehäuseöffnung gewartet werden, beispielsweise indem eine Sicherung ausgetauscht oder ein elektronisches Bauelement der elektronischen Schaltung ausgetauscht wird. Hierzu kann ebenfalls vorgesehen sein, dass die elektronische Schaltung aus dem Funktionsmodul entfernbar ausgeführt ist, beispielsweise nachdem Befestigungsschrauben gelöst werden.

Es kann vorgesehen sein, dass die Öffnungen des Gehäuses mit den Funktionsmodulen abgedeckt werden, so dass ein gemeinsames Gehäuse bestehend aus dem Gehäuse und den Modulgehäusen die elektronischen Schaltungen der Funktionsmodule und die ersten Anschlusselemente, die zweiten Anschlusselemente sowie die Datenleitung, die Kleinspannungsleitung und die Niederspannungsleitung umschließt.

In einer Ausführungsform ist die Gehäuseseite eben. In einer Ausführungsform ist die Modulgehäuseseite eben. Dabei kann es vorgesehen sein, dass sowohl die Gehäuseseite als auch die Modulgehäuseseite aller Funktionsmodule eben ist.

In einer Ausführungsform sind das erste Steckelement und das zweite Steckelement beabstandet voneinander angeordnet. Dies kann dadurch bedingt sein, dass die ersten Anschlusselemente und die zweiten Anschlusselemente des Basismoduls ebenfalls beabstandet voneinander angeordnet sind. Insbesondere können dadurch Daten und Kleinspannung an einer ersten Stelle vom Basismodul bereitgestellt und von den Funktionsmodulen abgegriffen werden und die Niederspannung an einer zweiten Stelle bereitgestellt beziehungsweise abgegriffen werden.

In einer Ausführungsform erstrecken sich die zweiten Anschlusselemente vom Inneren des Gehäuses durch die Öffnungen zum Äußeren des Gehäuses. Das zweite Steckelement ist im Inneren des Modulgehäuses angeordnet. Dadurch kann ein Abstand zwischen dem zweiten Anschlusselement und der Niederspannungsleitung vergrößert werden und dadurch Kriechströme reduziert werden.

In einer Ausführungsform erstrecken sich die zweiten Anschlusselemente vom Inneren des Gehäuses durch die Öffnungen zum Äußeren des Gehäuses. Das zweite Steckelement erstreckt sich durch die Modulgehäuseöffnung vom Inneren des Modulgehäuses zum Äußeren des Modulgehäuses. Auch hier können Kriechströme reduziert sein, wobei zusätzlich Kriechströme zwischen dem zweiten Steckelement und der elektronischen Schaltung reduziert sein können.

In einer Ausführungsform sind die zweiten Anschlusselemente im Inneren des Gehäuses im Bereich von Öffnungen angeordnet. Das zweite Steckelement erstreckt sich durch die Modulgehäuseöffnung vom Inneren des Modulgehäuses zum Äußeren des Modulgehäuses. Dadurch können Kriechströme zwischen dem zweiten Steckelement und der elektronischen Schaltung reduziert sein.

Es kann vorgesehen sein, dass die dritten Steckkontakte mit der Datenleitung und die vierten Steckkontakte mit der Kleinspannungsleitung verbunden sind.

In einer Ausführungsform umfassen die ersten Steckkontakte beziehungsweise die dritten Steckkontakte einen ersten Kommunikationsspannungskontakt, einen zweiten Kommunikationsspannungskontakt, ein erstes Datenanschlusselement, ein zweites Datenanschlusselement, ein drittes Datenanschlusselement, ein viertes Datenanschlusselement, ein fünftes Datenanschlusselement und ein sechstes Datenanschlusselement.

Über den ersten und zweiten Kommunikationsspannungskontakt kann eine zum Betrieb für Kommunikationselektronik nötige Spannung bereitgestellt werden, beispielsweise bis zu fünf Volt. Dadurch können Funktionsmodule, die nicht in die vierten Steckkontakte mit zweiten Steckkontakten eingreifen, mit der für Kommunikationselektronik nötigen Spannung versorgt werden.

Das erste Datenanschlusselement und das zweite Datenanschlusselement können zum Senden eines Kommunikationstelegramms vorgesehen sein. Das dritte Datenanschlusselement und das vierte Datenanschlusselement können der Abschirmung dienen. Das fünfte Datenanschlusselement und das sechste Datenanschlusselement können zum Empfangen eines Kommunikationstelegramms vorgesehen sein. Das Senden beziehungsweise Empfangen des Kommunikationstelegramms soll sich dabei auf die Übertragungsrichtung vom Funktionsmodul zum Basismodul beziehen. Im Basismodul sind entsprechende Steckkontakte zum Empfangen und Senden von Kommunikationstelegrammen vorgesehen. Die ersten bis sechsten Datenschlusselemente können zum Austausch von Daten vorgesehen sein, die auf dem EtherCAT Protokoll oder auf einem anderen Protokoll basieren.

Die ersten bis sechsten Datenanschlusselemente können dabei einen ersten Kommunikationskanal bilden. Es können weitere Datenanschlusselemente für weitere Kommunikationskanäle vorgesehen sein. Der erste Kommunikationskanal kann dabei bidirektional ausgestaltet sein und dadurch das gleichzeitigt Senden und Empfangen jeweils eines Kommunikationsprotokolls erlauben.

Es kann ferner vorgesehen sein, dass das erste Datenanschlusselement und das zweite Datenanschlusselement sowohl zum Senden als auch zum Empfangen eines Kommunikationstelegramms eingerichtet sind. Auch das fünfte Datenanschlusselement und das sechste Datenanschlusselement können zum Senden und Empfangen eines Kommunikationstelegramms eingerichtet sein. In diesem Fall ist eine Redundanz gegeben, so dass bei Ausfall einer Sende- beziehungsweise Empfangsrichtung die jeweils nicht betroffenen Datenanschlusselemente den Empfang beziehungsweise das Senden mit übernehmen können.

In einer Ausführungsform umfassen die zweiten Steckkontakte beziehungsweise vierten Steckkontakte zumindest einen ersten Gleichspannungskontakt, einen zweiten Gleichspannungskontakt, einen dritten Gleichspannungskontakt, einen vierten Gleichspannungskontakt, einen fünften Gleichspannungskontakt, einen sechsten Gleichspannungskontakt sowie einen Schutzleiteranschluss.

In einer Ausführungsform ist das Modulgehäuse durch die Modulgehäuseöffnung zugänglich, beispielsweise um eine Sicherung innerhalb des Funktionsmoduls auszutauschen und/oder um die elektronische Schaltung zu entnehmen.

Ein Funktionsmodul weist ein Modulgehäuse, eine elektronische Schaltung und ein Modulanschlusselement auf. Das Modulgehäuse weist eine Modulgehäuseseite und weitere Modulgehäuseseiten auf. Die Modulgehäuseseite weist eine Modulgehäuseöffnung auf. Das Modulanschlusselement weist ein erstes Steckelement auf, wobei sich das erste Steckelement durch die Modulgehäuseöffnung erstreckt und eingerichtet ist, in ein erstes Anschlusselement eines Basismoduls einzugreifen. Das Modulanschlusselement ist mit der elektronischen Schaltung verbunden, um elektrischen Kontakt zwischen dem Modulanschlusselement und der elektronischen Schaltung herzustellen. Das Funktionsmodul kann zum Einsatz in einem Schaltschranksystem vorgesehen sein. Das Modulgehäuse ist durch die Modulgehäuseöffnung zugänglich. Dadurch kann das Funktionsmodul mittels eines Eingriffs durch die Modulgehäuseöffnung gewartet werden, beispielsweise indem eine Sicherung ausgetauscht oder ein elektronisches Bauelement der elektronischen Schaltung ausgetauscht wird. Hierzu kann ebenfalls vorgesehen sein, dass die elektronische Schaltung aus dem Funktionsmodul entfernbar ausgeführt ist, beispielsweise nachdem Befestigungsschrauben gelöst werden.

Das erste Steckelement ist zumindest in einen ersten Bereich und einen zweiten Bereich unterteilt. Erste Steckkontakte zum Übertragen von Daten sind im ersten Bereich angeordnet. Zweite Steckkontakte zum Übertragen von Kleinspannung sind im zweiten Bereich angeordnet. Dadurch kann eine vorteilhaft aufgebaute Geometrie des ersten Steckelements erreicht werden, wobei die ersten Steckkontakte und die zweiten Stecckontakte unterschiedlich ausgestaltet sein können.

Das Modulanschlusselement umfasst ein zweites Steckelement umfasst, wobei das zweite Steckelement eingerichtet ist, in die zweiten Anschlusselemente des Basismoduls einzugreifen. Die ersten Steckkontakte und die zweiten Steckkontakte sind unterschiedlich ausgestaltet. Das erste Steckelement und das zweite Steckelement sind beabstandet voneinander angeordnet.

Um die Funktionalität eines Schaltschranks bereitzustellen, können die Funktionsmodule innerhalb des Schaltschranksystems als Eingangsmodule zum Auslesen von Sensordaten, als Ausgangsmodule zum Ausgeben von Spannungen, als SPS-Steuerungsmodule, als Motorsteuerungsmodule, als Netzteilmodule und/oder als Einspeisemodule ausgestaltet sein. Ein Einspeisemodul kann dabei die Aufgabe übernehmen, Daten, insbesondere in Form eines Feldbusses für das Basismodul bereitzustellen und/oder einer Spannungsversorgung des Basismoduls mit einer Kleinspannung und oder einer Niederspannung dienen. Ferner können Rechnermodule, Netzwerkswitchmodule, Servosteuerungsmodule, Netzfiltermodule, Schützmodule, Buskopplermodule, aktive oder passive Leistungsfaktorkorrekturmodule und/oder Frequenzumrichtermodule oder eine Kombination der genannten Module als Funktionsmodule ausgeführt sein.

Es kann vorgesehen sein, zusätzlich eine Dichtung zwischen dem Basismodul und den Funktionsmodulen anzubringen, um das System aus Basismodulen und Funktionsmodulen staub- und flüssigkeitsgeschützt auszuführen. Ein Schutz gegen Berühren kann bereits durch das Anbringen der Funktionsmodule am Basismodul und die dadurch erfolgende Abdeckung der Modulgehäuseöffnung der Funktionsmodule erfolgen. Dies ist insbesondere dann der Fall, wenn die Modulgehäuseöffnung dem Basismodul zugewendet ist. Dadurch wird einerseits die Wartung der Funktionsmodule erleichtert, da das Innere der Funktionsmodule zugänglich ist, sobald das Funktionsmodul vom Basismodul entfernt wird, und andererseits ein berührungssicheres und bevorzugt flüssigkeits- und staubdichtes System aus Basismodul und Funktionsmodulen bereitgestellt wird. Um die verschiedenen Aufgaben zu übernehmen, kann es vorgesehen sein, dass das Modulgehäuse auf einer der weiteren Modulgehäuseseiten weitere Anschlusselemente aufweist, die beispielsweise mit Sensoren, Aktoren oder anderen, typischerweise von einem Schaltschrank gesteuerten, Elementen verbunden sind.

In einer Ausführungsform dient das erste Steckelement der Übertragung von Daten. Dadurch kann ein Funktionsmodul bereitgestellt werden, das seinerseits Kommunikation mit anderen Elementen außerhalb des Schaltschranksystems übernimmt. Zusätzlich kann vorgesehen sein, dass das erste Steckelement der Übertragung von Kleinspannung dient.

In einer Ausführungsform weist das Modulanschlusselement ein zweites Steckelement auf, welches eingerichtet ist, in ein zweites Anschlusselement des Basismoduls einzugreifen. Das zweite Steckelement kann der Übertragung von Niederspannung dienen.

In einer Ausführungsform sind das erste Steckelement und das zweite Steckelement beabstandet voneinander angeordnet. Dadurch kann an unterschiedlichen Stellen in das erste Anschlusselement beziehungsweise das zweite Anschlusselement eingegriffen werden.

In einer Ausführungsform ist das zweite Steckelement im Inneren des Modulgehäuses angeordnet. Dies ermöglicht, in ein zweites Anschlusselement einzugreifen, welches durch eine Öffnung eines Gehäuses eines Basismoduls geführt ist.

In einer Ausführungsform erstreckt sich das zweite Steckelement durch die Modulgehäuseöffnung vom Innern des Modulgehäuses zum Äußeren des Modulgehäuses. Dies ermöglicht den Eingriff in ein zweites Anschlusselement eines Basismoduls, das entweder im Innern eines Gehäuses des Basismoduls angeordnet ist oder auch den Eingriff in ein zweites Anschlusselement des Basismoduls, wobei das zweite Anschlusselement durch eine Öffnung eines Gehäuses eines Basismoduls geführt ist, je nach Ausgestaltung des zweiten Anschlusselements beziehungsweise zweiten Steckelements.

In einer Ausführungsform umfassen die ersten Steckkontakte einen ersten Kommunikationsspannungskontakt, einen zweiten Kommunikationsspannungskontakt, ein erstes Datenanschlusselement, ein zweites Datenanschlusselement, ein drittes Datenanschlusselement, ein viertes Datenanschlusselement, ein fünftes Datenanschlusselement und ein sechstes Datenanschlusselement.

Über den ersten und zweiten Kommunikationsspannungskontakt kann das Funktionsmodul mit einer zum Betrieb für Kommunikationselektronik nötigen Spannung versorgt werden, beispielsweise bis zu fünf Volt. Dadurch können Funktionsmodule, die keine zweiten Steckkontakte aufweisen, mit der für Kommunikationselektronik nötigen Spannung versorgt werden.

Das erste Datenanschlusselement und das zweite Datenanschlusselement können zum Senden eines Kommunikationstelegramms vorgesehen sein. Das dritte Datenanschlusselement und das vierte Datenanschlusselement können der Abschirmung dienen. Das fünfte Datenanschlusselement und das sechste Datenanschlusselement können zum Empfangen eines Kommunikationstelegramms vorgesehen sein. Die ersten bis sechsten Datenanschlusselemente können zum Austausch von Daten vorgesehen sein, die auf dem EtherCAT Protokoll oder auf einem anderen Protokoll basieren.

Es kann ferner vorgesehen sein, dass das erste Datenanschlusselement und das zweite Datenanschlusselement sowohl zum Senden als auch zum Empfangen eines Kommunikationstelegramms eingerichtet sind. Auch das fünfte Datenanschlusselement und das sechste Datenanschlusselement können zum Senden und Empfangen eines Kommunikationstelegramms eingerichtet sein. In diesem Fall ist eine Redundanz gegeben, so dass bei Ausfall einer Sende- beziehungsweise Empfangsrichtung die jeweils nicht betroffenen Datenanschlusselemente den Empfang beziehungsweise das Senden mit übernehmen können.

Die ersten bis sechsten Datenanschlusselemente können dabei einen ersten Kommunikationskanal bilden. Es können weitere Datenanschlusselemente für weitere Kommunikationskanäle vorgesehen sein. Der erste Kommunikationskanal kann dabei bidirektional ausgestaltet sein und dadurch das gleichzeitigt Senden und Empfangen jeweils eines Kommunikationsprotokolls erlauben.

In einer Ausführungsform umfassen die zweiten Steckkontakte zumindest einen ersten Gleichspannungskontakt, einen zweiten Gleichspannungskontakt, einen dritten Gleichspannungskontakt, einen vierten Gleichspannungskontakt, einen fünften Gleichspannungskontakt, einen sechsten Gleichspannungskontakt sowie einen Schutzleiteranschluss. Dabei kann zwischen dem ersten Gleichspannungskontakt und dem zweiten Gleichspannungskontakt eine dauerhafte Gleichspannung mit vierundzwanzig Volt, zwischen dem dritten Gleichspannungskontakt und dem vierten Gleichspannungskontakt eine schaltbare Gleichspannung mit vierundzwanzig Volt und zwischen dem fünften Gleichspannungskontakt und dem sechsten Gleichspannungskontakt eine dauerhafte Gleichspannung mit achtundvierzig Volt übertragen werden.

In einer Ausführungsform ist das Modulgehäuse durch die Modulgehäuseöffnung zugänglich, beispielsweise um eine Sicherung innerhalb des Funktionsmoduls auszutauschen und/oder um die elektronische Schaltung zu entnehmen.

In einer Ausführungsform weist das Modulgehäuse ein Metall auf. Insbesondere kann das Modulgehäuse aus einem Metall bestehen. Das Metall kann dabei insbesondere Aluminium und/oder Zink umfassen.

In einer Ausführungsform besteht das Modulgehäuse aus einem Stangenpressprofil. In einer Ausführungsform ist das Modulgehäuse ein Druckgussgehäuse. Beide Gehäuseformen eignen sich besonders gut für Metallgehäuse, insbesondere wenn die Metallgehäuse als Aluminiumstangenpressprofile oder Zinkdruckgussgehäuse ausgestaltet sind.

In einer Ausführungsform weist das Funktionsmodul eine Sicherung auf, wobei mittels der Sicherung das Modulanschlusselement abgesichert ist. Dies bedeutet, dass die Sicherung zwischen dem Modulanschlusselement und der elektronischen Schaltung angeordnet ist. Die Sicherung dann dabei insbesondere im Inneren des Modulgehäuses angeordnet sein und durch die Modulgehäuseöffnung zugänglich sein. Dadurch wird einerseits eine Absicherung der elektronischen Schaltung des Funktionsmoduls erreicht und andererseits ist die Sicherung einfach austauschbar.

In einer Ausführungsform des Funktionsmoduls weist dieses eine Abdeckung auf, die derart am Modulgehäuse befestigt ist, dass die Modulgehäuseöffnung zumindest teilweise abgedeckt ist und die Abdeckung entfernbar ist. Da mittels dieser Abdeckung weder ein Staubschutz noch ein Berührungsschutz noch ein Schutz gegen das Eindringen von Flüssigkeiten erzeugt werden muss, da diese Schutzkategorien bereits durch das Anbringen des Funktionsmoduls am Basismodul erreicht werden, kann die Abdeckung beispielsweise ohne Dichtung in die Modulgehäuseöffnung eingesetzt werden und ist dadurch einfach und insbesondere ohne den Einsatz von Werkzeug entfernbar. Durch die Abdeckung kann eine gewisse Berührungssicherheit hergestellt werden, insbesondere, wenn durch die Abdeckung Teile der elektronischen Schaltung abgedeckt werden.

In einer Ausführungsform weist das Modulgehäuse passive Kühlelemente, insbesondere Kühlrippen und/oder Kühlfinnen, auf. Dadurch kann ein Wärmetransport vom Inneren des Modulgehäuses nach außen erfolgen und ein Wärmeaustausch mit der Umgebungsluft verbessert werden.

In einer Ausführungsform ist das Modulgehäuse derart ausgeführt, dass das Modulgehäuse an einem Basismodul befestigt werden kann. Dies kann beispielsweise durch Durchgangslöcher am Modulgehäuse erfolgen, mit denen das Modulgehäuse am Basismodul verschraubt werden kann. Hierzu kann das Basismodul entsprechende Gewindelöcher aufweisen. Alternativ oder zusätzlich kann das Modulgehäuse eine Schnalle aufweisen, der zum Verschließen in ein Gegenstück des Basismoduls eingehängt werden kann.

In einer Ausführungsform weist das Funktionsmodul eine Leiterkarte auf, wobei die elektronische Schaltung zumindest teilweise auf der Leiterkarte angeordnet ist. Auch das Modulanschlusselement, insbesondere das erste Steckelement beziehungsweise das zweite Steckelement, kann beziehungsweise können auf der Leiterkarte angeordnet sein, sodass insgesamt ein kompakter Aufbau der elektronischen Schaltung des Funktionsmoduls möglich wird.

In einer Ausführungsform ist die Modulgehäuseseite eben.

Die Erfindung wird nachfolgend anhand von Ausführungsbeispielen und unter Bezugnahme auf Figuren näher erläutert. Dabei zeigen jeweils in schematisierter Darstellung
- Fig. 1: eine isometrische Ansicht eines Funktionsmoduls;
- Fig. 2: eine gedrehte Draufsicht auf das Funktionsmodul;
- Fig. 3: eine Draufsicht auf ein weiteres Funktionsmodul;
- Fig. 4: eine gedrehte isometrische Ansicht des weiteren Funktionsmoduls;
- Fig. 5: eine Draufsicht auf ein weiteres Funktionsmodul;
- Fig. 6: eine isometrische Ansicht und eine Draufsicht auf ein erstes Steckelement;
- Fig. 7 bis 10: Modulgehäuse mit Kühlrippen beziehungsweise Kühlfinnen;
- Fig. 11: einen Querschnitt durch ein weiteres Funktionsmodul;
- Fig. 12: ein Schaltschranksystem aus Basismodul und mehreren Funktionsmodulen;
- Fig. 13: einen Querschnitt durch ein Schaltschranksystem aus Basismodul und Funktionsmodulen;
- Fig. 14: eine Draufsicht auf ein weiteres Funktionsmodul;
- Fig. 15: einen Querschnitt durch ein weiteres Funktionsmodul;
- Fig. 16: einen Querschnitt durch ein weiteres Schaltschranksystem aus Basismodul und mehreren Funktionsmodulen;
- Fig. 17: einen weiteren Querschnitt des weiteren Schaltschranksystem;
- Fig. 18: einen weiteren Querschnitt des weiteren Schaltschranksystem;
- Fig. 19: eine Ansicht des weiteren Schaltschranksystem;
- Fig. 20: ein Modulgehäuse;
- Fig. 21: eine isometrische Ansicht eines weiteren Basismoduls;
- Fig. 22: eine isometrische Ansicht eines weiteren Schaltschranksystem;
- Fig. 23: eine isometrische Ansicht eines weiteren Funktionsmoduls; und
- Fig. 24: ein erstes Anschlusselement.

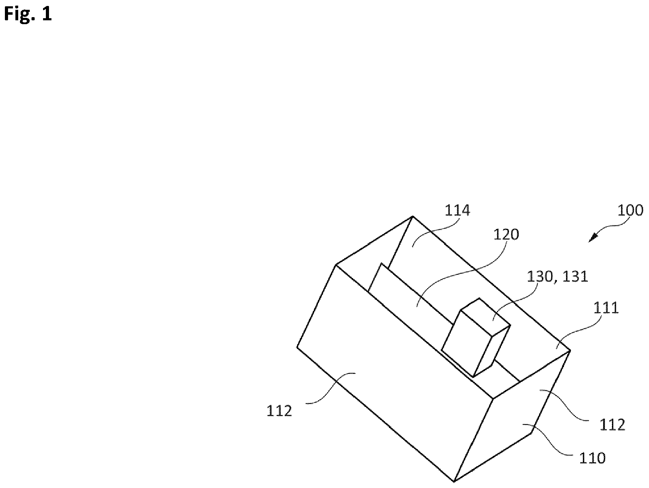

Fig. 1 zeigt eine isometrische Draufsicht auf ein Funktionsmodul 100 für ein Schaltschranksystem. Das Funktionsmodul 100 weist ein Modulgehäuse 110 mit einer Modulgehäuseseite 111 und weiteren Modulgehäuseseiten 112 auf. Innerhalb des Modulgehäuses 110 ist eine elektronische Schaltung 120 angeordnet, mit der ein Modulanschlusselement 130 verbunden ist. Die Modulgehäuseseite 111 weist eine Modulgehäuseöffnung 114 auf, die sich im Wesentlichen über die gesamte Modulgehäuseseite 111 erstreckt. Das Modulanschlusselement 130 ist als erstes Steckelement 131 ausgestaltet und erstreckt sich durch die Modulgehäuseöffnung 114 vom Inneren des Modulgehäuses 110 zum Äußeren des Modulgehäuses 110. Das Modulanschlusselement 130 ist ferner eingerichtet, in ein erstes Anschlusselement eines Basismoduls einzugreifen. Es kann vorgesehen sein, mittels des ersten Steckelements 131 Daten oder Daten und Kleinspannung zu übertragen.

Je nachdem, welche Funktion das Funktionsmodul 100 übernehmen soll, kann die elektronische Schaltung 120 unterschiedlich ausgestaltet sein. Ferner kann das Modulgehäuse 110 je nach Ausgestaltung der elektronischen Schaltung 120 unterschiedlich ausgestaltet sein.

Um verschiedene Funktionalitäten eines Schaltschranks bereitzustellen, kann das Funktionsmodul 100 als Eingangsmodul zum Auslesen von Sensordaten, als Ausgangsmodul zum Ausgeben von Spannungen, als SPS-Steuerungsmodul, als Motorsteuerungsmodul, als Netzteilmodul und/oder als Einspeisemodul ausgestaltet sein. Ein Einspeisemodul kann dabei die Aufgabe übernehmen, den Feldbus für ein Basismodul bereitzustellen und/oder einer Spannungsversorgung des Basismoduls mit einer Kleinspannung und/oder einer Niederspannung dienen. Ferner kann das Funktionsmodul 100 als Rechnermodul, Netzwerkswitchmodul, Servosteuerungsmodul, Netzfiltermodul, Schützmodul, Buskopplermodul, aktives oder passives Leistungsfaktorkorrrekturmodul und/oder Frequenzumrichtermodul oder als eine Kombination der genannten Module ausgeführt sein.

Das Steckelement 131 kann dabei als Stecker oder als Buchse ausgeführt sein, wobei in der Darstellung der Fig. 1 die genaue Ausgestaltung des Steckelements offengelassen ist.

Wie in Fig. 1 dargestellt, kann die Modulgehäuseseite 111 eben sein.

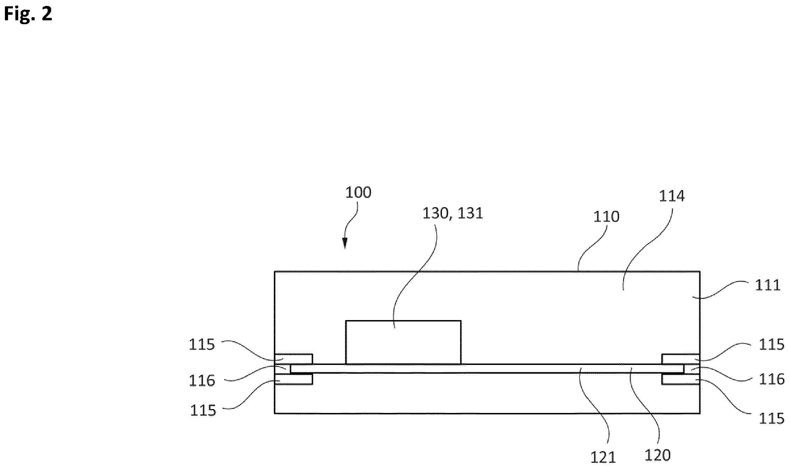

Fig. 2 zeigt eine gedrehte Draufsicht auf die Modulgehäuseseite 111 des Funktionsmoduls 100 der Fig. 1. Die elektronische Schaltung 120 ist dabei auf einer Modulleiterkarte 121 angeordnet, wobei dies bedeutet, dass elektronische Bauteile der elektronischen Schaltung 120 auf der Modulleiterkarte 121 angeordnet und mittels Leiterbahnen miteinander verbunden sind. Das Modulanschlusselement 130 ist ebenfalls auf der Modulleiterkarte 121 angeordnet. Das Modulgehäuse 110 weist zusätzlich Vorsprünge 115 auf, durch die Führungsnuten 116 gebildet werden, wobei die Modulleiterkarte 121 innerhalb der Führungsnuten 116 innerhalb des Modulgehäuses 110 geführt ist. Die Vorsprünge 115 und die Führungsnuten 116 sind dabei nicht bis zur Modulgehäuseseite 111 geführt und deshalb in Fig. 1 nicht sichtbar. Alternativ ist es möglich, die Vorsprünge 115 und die Führungsnuten 116 bis zur Modulgehäuseseite 111 zu führen. Ferner können Befestigungsmittel zum Befestigen der Modulleiterkarte 121 innerhalb des Modulgehäuses 110 vorgesehen sein.

Durch die Modulgehäuseöffnung 114 ist das Modulgehäuse 110 zugänglich, beispielsweise um die Modulleiterkarte 121 zu entnehmen und die elektronische Schaltung 120 zu reparieren.

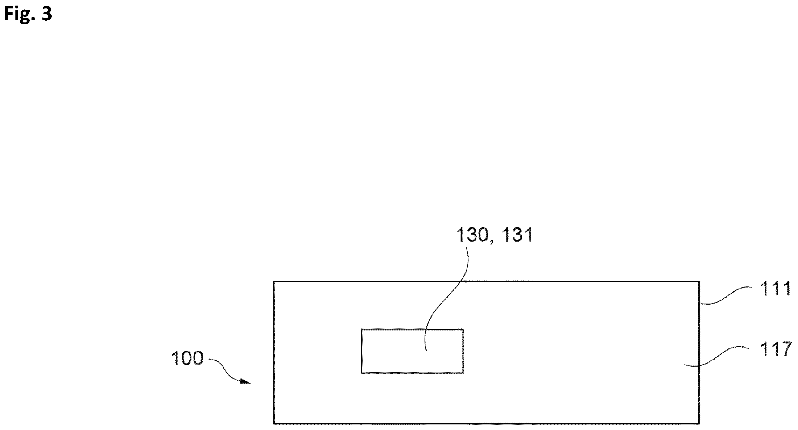

Fig. 3 zeigt eine Draufsicht auf ein Funktionsmodul 100, welches dem Funktionsmodul der Fig. 1 und 2 entspricht, sofern im Folgenden keine Unterschiede beschrieben sind. Das Funktionsmodul 100 weist eine Abdeckung 117 auf, wobei mittels der Abdeckung 117 die Modulgehäuseöffnung 114 im Wesentlichen verschlossen ist. Dadurch sind in der Draufsicht die Modulleiterkarte 121 sowie die Vorsprünge 115 und Führungsnuten 116 des Funktionsmoduls 100 der Fig. 1 und 2 nicht mehr sichtbar, können jedoch hinter der Abdeckung 117 weiter vorhanden sein. Die Abdeckung 117 ist derart ausgestaltet, dass das Modulanschlusselement 130 durch die Abdeckung 117 geführt ist. Die Abdeckung 117 kann dabei aus einem Kunststoff bestehen und in das Modulgehäuse 110 eingesetzt, insbesondere eingeklippst, sein. Durch die Abdeckung 117 wird die elektronische Schaltung gegen Berührungen geschützt.

Alternativ oder zusätzlich zur Abdeckung 117 kann vorgesehen sein, dass Modulgehäuse 110 mit einem elektrisch isolierenden Material zu vergießen.

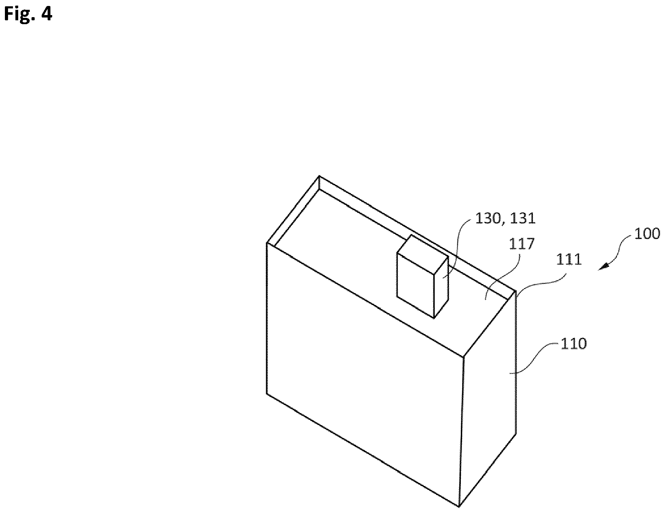

Fig. 4 zeigt eine gedrehte isometrische Ansicht des Funktionsmoduls 100 der Fig. 3. Wie in Fig. 4 dargestellt ist, ist die Abdeckung 117 nicht direkt an der Modulgehäuseseite 111, sondern etwas in das Modulgehäuse 110 hinein versetzt angeordnet. Die Abdeckung 117 kann jedoch auch auf Höhe der Modulgehäuseseite 111 angeordnet sein.

In einem Ausführungsbeispiel wird über das Modulanschlusselement 130 ein Datenmodulanschluss beziehungsweise ein Kleinspannungsmodulanschluss bereitstellt. Ferner kann ein Niederspannungsmodulanschluss über das Modulanschlusselement 130 bereitgestellt werden.

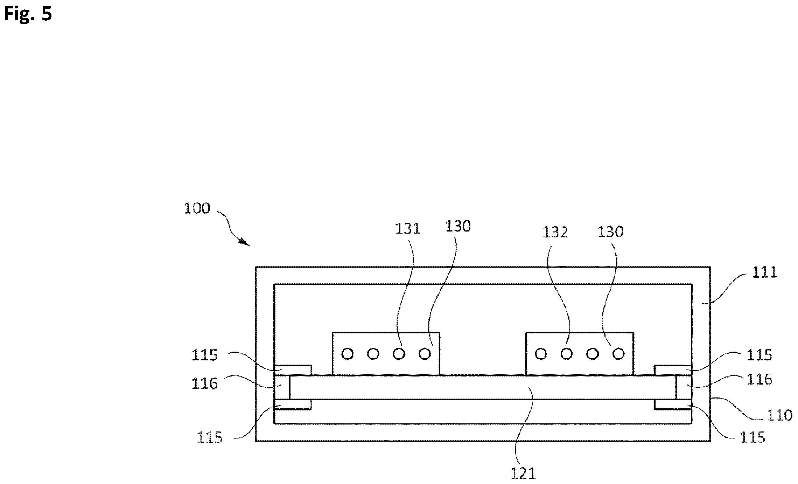

Fig. 5 zeigt eine Draufsicht auf ein Funktionsmodul 100, welches dem Funktionsmodul der Fig. 1 und 2 entspricht, sofern im Folgenden keine Unterschiede beschrieben sind. Insbesondere weist das Funktionsmodul 100 keine Abdeckung analog zu den Fig. 3 oder 4 auf, wobei eine solche Abdeckung jedoch ebenfalls vorgesehen werden könnte. Das Modulanschlusselement 130 ist bei diesem Funktionsmodul 100 in ein erstes Steckelement 131 und ein zweites Steckelement 132 aufgeteilt. Das erste Steckelement 131 ist eingerichtet, in ein erstes Anschlusselement eines Basismoduls einzugreifen. Das zweite Steckelement 132 ist eingerichtet, in ein zweites Anschlusselement eines Basismoduls einzugreifen. Das erste Steckelement 131 und das zweite Steckelement 132 sind dabei beabstandet zueinander ausgeführt. Es kann vorgesehen sein, mittels des ersten Steckelements 131 Daten oder Daten und Kleinspannung zu übertragen. Es kann vorgesehen sein, mittels des zweiten Steckelements 132 Niederspannung zu übertragen.

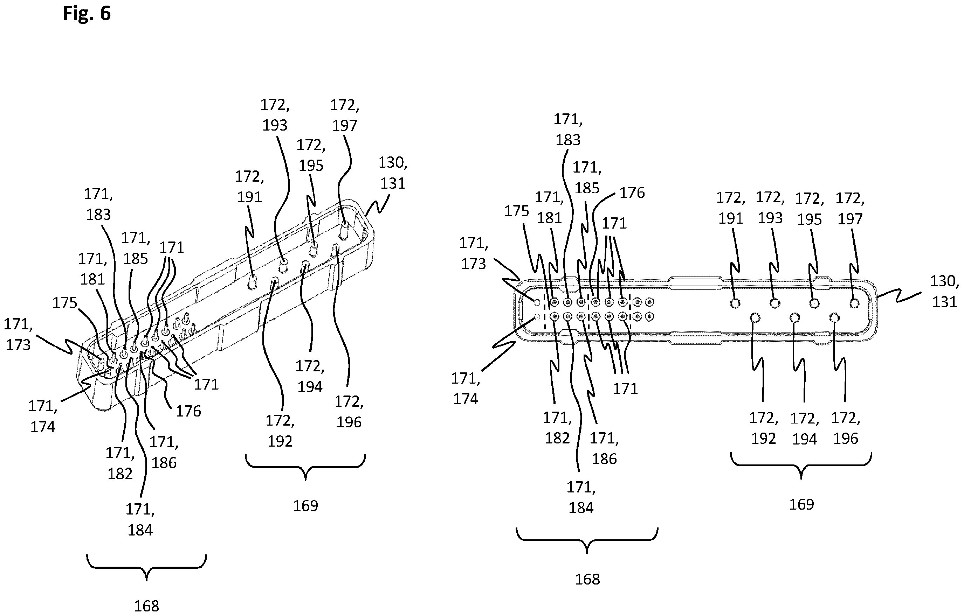

Fig. 6 zeigt eine isometrische Ansicht und eine Draufsicht auf ein weiteres erstes Steckelement 131, das als Anschlusselement 130 für ein Funktionsmodul dienen kann. Das erste Steckelement 131 weist einen ersten Bereich 168 und einen zweiten Bereich 169 auf. Im ersten Bereich 168 sind erste Steckkontakte 171 angeordnet. Die ersten Steckkontakte 171 sind zum Übertragen von Daten vorgesehen. Im zweiten Bereich 169 sind zweite Steckkontakte 172 angeordnet. Die zweiten Steckkontakte 172 sind zum Übertragen von Kleinspannung vorgesehen. Die ersten Steckkontakte 171 sind dabei jeweils paarweise angeordnet, während die zweiten Steckkontakte 172 in einer Zickzacklinie angeordnet sind.

Die ersten Steckkontakte 171 umfassen dabei einen ersten Kommunikationsspannungskontakt 173, einen zweiten Kommunikationsspannungskontakt 174, ein erstes Datenanschlusselement 181, ein zweites Datenanschlusselement 182, ein drittes Datenanschlusselement 183, ein viertes Datenanschlusselement 184, ein fünftes Datenanschlusselement 185 und ein sechstes Datenanschlusselement 186. Das erste bis sechste Datenanschlusselement 181, 182, 183, 184, 185, 186 bilden dabei einen ersten Kommunikationskanal 175. Weitere erste Stecckontakte 171 bilden einen zweiten Kommunikationskanal 176, der analog zum ersten Kommunikationskanal ausgebildet sein kann.

Über den ersten Kommunikationsspannungskontakt 173 und den zweiten Kommunikationsspannungskontakt 174 kann das Funktionsmodul mit einer zum Betrieb für Kommunikationselektronik nötigen Spannung versorgt werden, beispielsweise bis zu fünf Volt. Dadurch können Funktionsmodule, die keine zweiten Steckkontakte 172 aufweisen, mit der für Kommunikationselektronik nötigen Spannung versorgt werden.

Das erste Datenanschlusselement 181 und das zweite Datenanschlusselement 182 können zum Senden eines Kommunikationstelegramms vorgesehen sein. Das dritte Datenanschlusselement 183 und das vierte Datenanschlusselement 184 können der Abschirmung dienen. Das fünfte Datenanschlusselement 185 und das sechste Datenanschlusselement 186 können zum Empfangen eines Kommunikationstelegramms vorgesehen sein. Die ersten bis sechsten Datenanschlusselemente 181, 182, 183, 184, 185, 186 können zum Austausch von Daten vorgesehen sein, die auf dem EtherCAT Protokoll oder auf einem anderen Protokoll basieren. Der erste Kommunikationskanal 175 kann also zum Austausch von Daten vorgesehen sein, die auf dem EtherCAT Protokoll oder auf einem anderen Protokoll basieren. Analog kann der zweite Kommunikationskanal 176 ausgestaltet sein. Der erste Kommunikationskanal 175 und der zweite Kommunikationskanal 176 können dabei bidirektional ausgestaltet sein und dadurch das gleichzeitigt Senden und Empfangen jeweils eines Kommunikationsprotokolls erlauben.

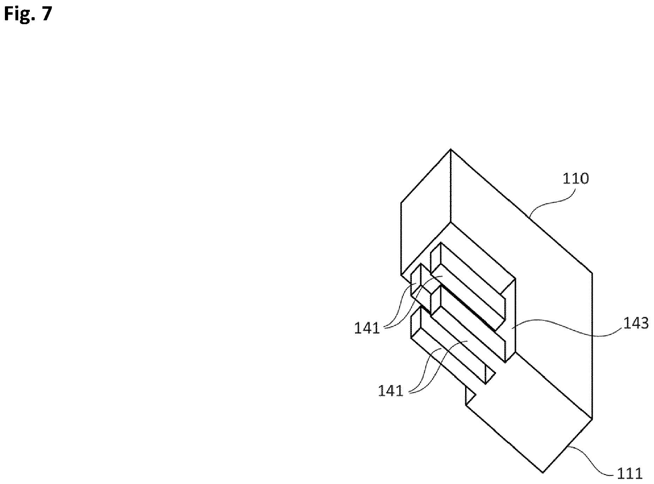

Die zweiten Steckkontakte 172 umfassen einen ersten Gleichspannungskontakt 191, einen zweiten Gleichspannungskontakt 192, einen dritten Gleichspannungskontakt 193, einen vierten Gleichspannungskontakt 194, einen fünften Gleichspannungskontakt 195, einen sechsten Gleichspannungskontakt 196 sowie einen Schutzleiteranschluss 197. Dabei kann zwischen dem ersten Gleichspannungskontakt 191 und dem zweiten Gleichspannungskontakt 192 eine dauerhafte Gleichspannung mit vierundzwanzig Volt, zwischen dem dritten Gleichspannungskontakt 193 und dem vierten Gleichspannungskontakt 194 eine schaltbare Gleichspannung mit vierundzwanzig Volt und zwischen dem fünften Gleichspannungskontakt 195 und dem sechsten Gleichspannungskontakt 196 eine dauerhafte Gleichspannung mit achtundvierzig Volt übertragen werden
Fig. 7 zeigt ein Modulgehäuse 110, bei dem passive Kühlelemente, hier ausgeführt als Stabkühlkörper 141, einen Teil des Modulgehäuses 110 bilden. Über die Stabkühlkörper 141 ist eine Kühlung des Inneren des Modulgehäuses 110 möglich.

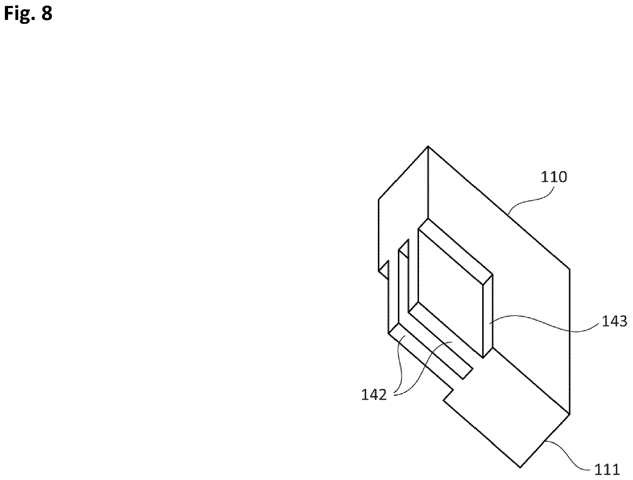

Fig. 8 zeigt ein weiteres Modulgehäuse 110, bei dem die passiven Kühlelemente anstelle von Stabkühlkörper als Strangkühlkörper 142 ausgestaltet sind. Die Stabkühlkörper 141 der Fig. 7 beziehungsweise die Strangkühlkörper 142 der Fig. 8 sind dabei nicht über gesamte Modulgehäuse 110 geführt, sondern nur über einen Teilbereich 143.

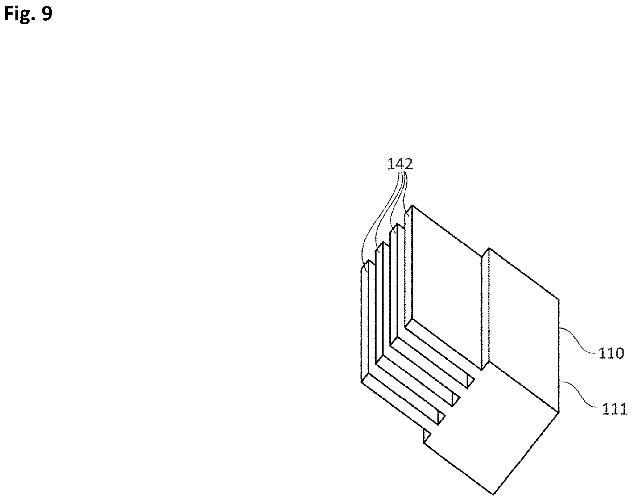

Fig. 9 zeigt ebenfalls ein weiteres Modulgehäuse 110, bei dem Strangkühlkörper 142 über das gesamte Modulgehäuse 110 geführt sind. Die Stabkühlkörper 141 der Fig. 7 beziehungsweise die Strangkühlkörper 142 der Fig. 8 und 9 sind dabei gegenüber der Modulgehäuseseite mit der Modulgehäuseöffnung 114 angeordnet.

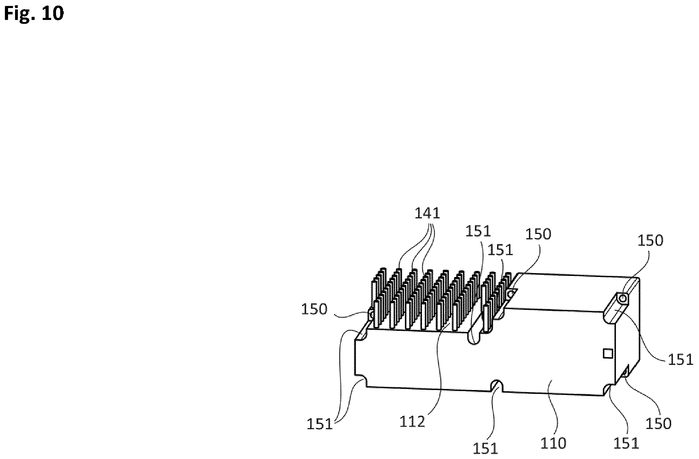

Fig. 10 zeigt ein weiteres Modulgehäuse 110, bei dem die Stabkühlkörper 141 auf einer weiteren Modulgehäuseseite 112 angeordnet sind. Die Stabkühlkörper 141 sind dabei seitlich am Modulgehäuse 110 und nicht der Modulgehäuseseite mit der Modulgehäuseöffnung gegenüberliegend angeordnet. Ferner weist das Modulgehäuse 110 der Fig. 10 Durchgangslöcher 150 auf, die durch Ausnehmungen 151 zugänglich sind. Durch die Durchgangslöcher 150 können beispielsweise Schrauben geführt werden, um das Modulgehäuse 110 und damit ein Funktionsmodul an einem Basismodul zu befestigen. Durch die Ausnehmungen 151 sind dabei die Schraubenköpfe entsprechend zugänglich, um die Verschraubung zu ermöglichen.

Um einen sicheren Halt des Funktionsmoduls an einem Basismodul zu gewährleisten, können mindestens vier Durchgangslöcher 150 vorgesehen werden. Je nach Größe des Funktionsmoduls können auch mehr als vier Durchgangslöcher 150 vorgesehen werden.

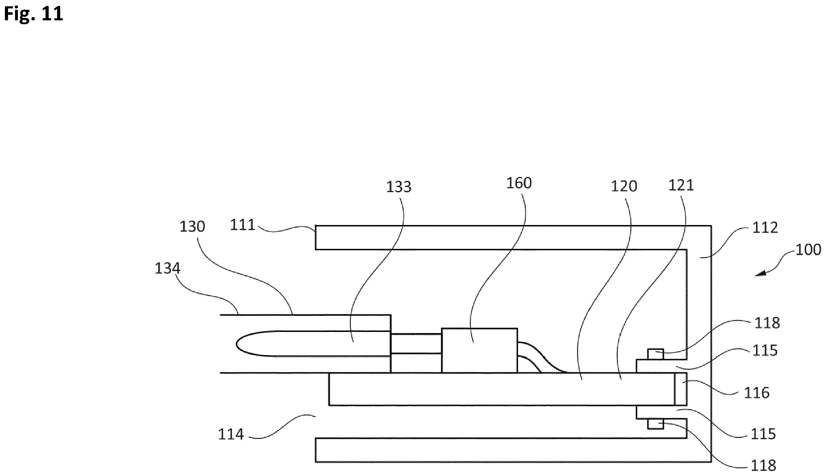

Fig. 11 zeigt einen Querschnitt durch ein Funktionsmodul 100. Im Inneren weist das Modulgehäuse 110 auf einer der Modulgehäuseöffnung 114 gegenüberliegenden weiteren Modulgehäuseseite 112 ebenfalls Vorsprünge 115 auf, die eine Führungsnut 116 bilden und in die eine Modulleiterkarte 121 der elektronischen Schaltung 120 geführt ist. Im Bereich der Vorsprünge 115 ist die Modulleiterkarte 121 mittels Befestigungsmitteln 118 befestigt. Solche Befestigungsmittel 118 können alternativ oder zusätzlich auch an den Vorsprüngen und Führungsnuten der Fig. 2 beziehungsweise Fig. 5 vorgesehen werden.

Das Modulanschlusselement 130 ist als Stecker 133 mit einem Schutzgehäuse 134 ausgestaltet. Das Schutzgehäuse 134 überragt dabei den Stecker 133 derart, dass der Stecker 133 und damit das Modulanschlusselement 130 berührungssicher ausgestaltet ist.

Ferner weist die elektronische Schaltung 120 eine optionale Sicherung 160 zwischen dem Stecker 133 und der Modulleiterkarte 121 auf. Mittels der Sicherung 160 kann, sollte durch den Stecker 133 ein zu großer Strom fließen, die Modulleiterkarte 121 vor diesem zu großen Strom geschützt werden. Durch die Modulgehäuseöffnung 114 ist die Sicherung 160 zugänglich und kann im Falle eines Auslösens einfach ausgetauscht werden.

Sowohl der berührungssichere Stecker 133 mit dem Schutzgehäuse 134 als auch die Sicherung 160 können unabhängig voneinander in einem Funktionsmodul 100 realisiert werden.

Der Stecker 133 kann dabei Teil des in den Fig. 5 und 6 gezeigten ersten Steckelements 131 beziehungsweise Teil des in Fig. 5 gezeigten zweiten Steckelements 132 sein.

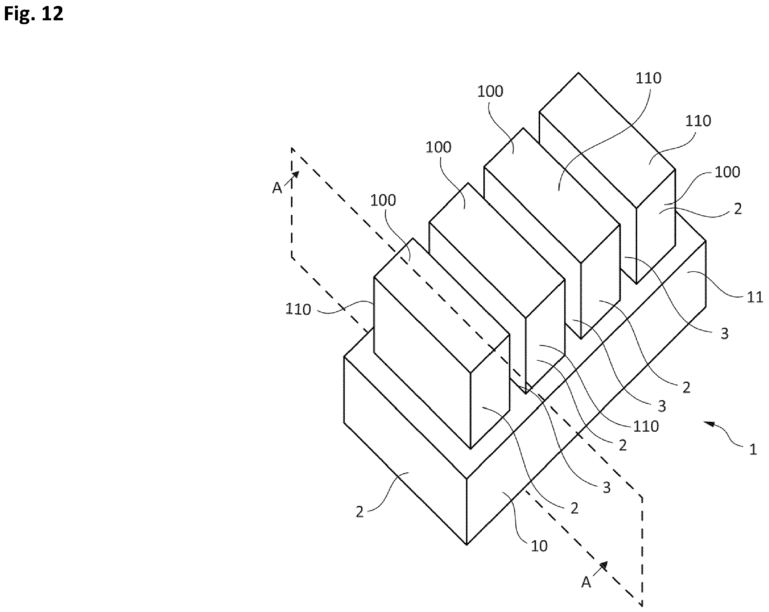

Fig. 12 zeigt eine isometrische Draufsicht auf ein Schaltschranksystem 1, bestehend aus einem Basismodul 10 und vier Funktionsmodulen 100. Zwischen den Funktionsmodulen 100 ist ein Zwischenraum 3 frei, der zu einer Belüftung der Funktionsmodule 100 genutzt werden kann. Sollte eines der Funktionsmodule 100 einen größeren Kühlungsbedarf haben, kann anstelle der dargestellten Modulgehäuse 110 eines der in den Fig. 7 bis 10 gezeigten Modulgehäuse 110 verwendet werden.

Die Funktionsmodule 100 können dabei gemäß einer der Fig. 1 bis 11 ausgestaltet sein. Das Basismodul 10 stellt eine Datenleitung, eine Kleinspannungsleitung sowie optional eine Niederspannungsleitung zur Verfügung und weist Kleinspannungsanschlüsse, Datenanschlüsse sowie optional Niederspannungsanschlüsse auf. Die Modulanschlusselemente der Funktionsmodule 100 können in diese Anschlusselemente des Basismoduls eingreifen. Dadurch kann zwischen den Funktionsmodulen 100 eine Kommunikationsverbindung sowie eine Spannungsversorgung für die Funktionsmodule 100 bereitgestellt werden.

Die Modulgehäuse 110 und das Gehäuse 11 bilden ein gemeinsames Gehäuse 2 des Schaltschranksystems 1, wobei durch das gemeinsame Gehäuse 2 sämtliche Öffnungen des Gehäuses 11 sowie der Modulgehäuse 110 verschlossen sind und so ein berührungsgeschütztes, staub- und flüssigkeitsdichtes Schaltschranksystem 1 bereitgestellt wird.

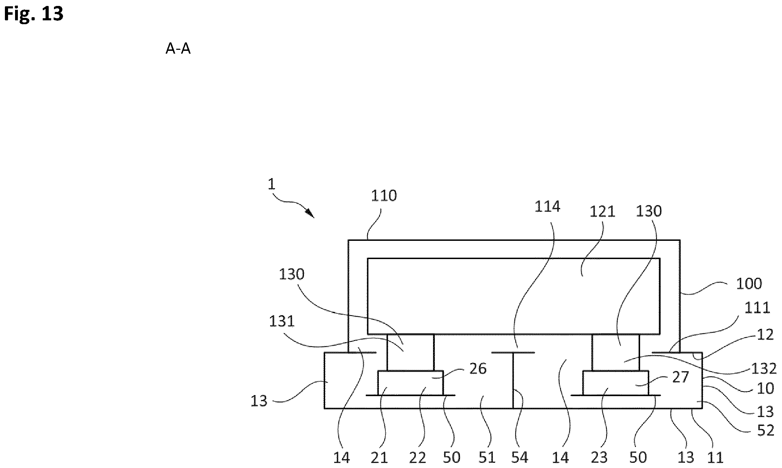

Fig. 13 zeigt einen Querschnitt durch das Schaltschranksystem 1 der Fig. 12 an der mit A bezeichneten Schnittebene. Das Basismodul 10 weist ein Gehäuse 11 mit einer Gehäuseseite 12 und weiteren Gehäuseseiten 13 auf. Auf der Gehäuseseite 12 weist das Gehäuse 11 zwei Öffnungen 14 auf. Innerhalb des Gehäuses 11 ist eine Trennwand 54 angeordnet, wobei zwei Kanäle, also ein erster Kanal 51 und ein zweiter Kanal 52 mittels der Trennwand 54 voneinander getrennt werden. In dem ersten Kanal 51 ist eine Leiterkarte 50, die als Daten- und Kleinspannungsleiterkarte 48 ausgestaltet ist, mit einem ersten Anschlusselement 26 angeordnet, wobei das erste Anschlusselement 26 einen Datenanschluss 21 und einen Kleinspannungsanschluss 22 bereitstellt. In dem zweiten Kanal 52 ist ebenfalls eine Leiterkarte 50, die als Niederspannungsleiterkarte 49 ausgestaltet ist, mit einem zweiten Anschlusselement 27 angeordnet, wobei das zweite Anschlusselement 27 einen Niederspannungsanschluss 23 bereitstellt. Das Funktionsmodul 100 weist ein Modulgehäuse 110 mit einer Modulgehäuseöffnung 114 auf der Modulgehäuseseite 111 auf. Durch die Modulgehäuseöffnung 114 sind zwei Modulanschlusselemente 130, ein erstes Steckelement 131 und ein zweites Steckelement 132, analog zur Fig. 5, geführt. Das erste Steckelement 131 greift dabei in das erste Anschlusselement 26 im ersten Kanal 51 ein, während das zweite Steckelement 132 in das zweite Anschlusselement 27 des zweiten Kanals 52 eingreift. Die Modulleiterkarte 121 des Funktionsmoduls wird somit an den Datenanschluss 21, den Kleinspannungsanschluss 22 und den Niederspannungsanschluss 23 angeschlossen.

Sollte das Funktionsmodul 100 im Gegensatz zur Darstellung der Fig. 13 beispielsweise keine Niederspannung benötigen, so kann das zweite Steckelement 132 entweder weggelassen oder nicht mit der Modulleiterkarte 121 verbunden werden.

Alternativ zur Darstellung der Fig. 13 kann das zweite Anschlusselement 27 auch durch die darüber liegende Öffnung 14 geführt sein und damit auch teilweise oberhalb der Gehäuseseite 12 angeordnet sein. Das zweite Steckelement 132 kann dann innerhalb des Modulgehäuses 110 angeordnet sein.

Wenn das Modulgehäuse 110 mit Durchgangslöchern 150 analog zur Fig. 10 ausgestattet ist, kann das Gehäuse 11 entsprechende Gewindelöcher aufweisen, in denen ein Innengewinde einer Verschraubung des Funktionsmoduls 100 am Basismodul 10 dienen kann. Dies ist in Fig. 13 nicht dargestellt.

Entgegen der Darstellung in Fig. 12 und 13 ist es nicht zwingend erforderlich, dass das Modulgehäuse 110 in etwa das Gehäuse 10 abdeckt. Sollten nach dem Anbringen des Funktionsmoduls 100 am Basismodul 10 noch Öffnungen 14 nicht abgedeckt sein, kann für diese Öffnungen 14 ein Deckel vorgesehen werden. Das Modulgehäuse 110 kann auch über das Gehäuse 10 hinausragen.

Das Gehäuse 11 beziehungsweise das Modulgehäuse 110 kann dabei als Stangenpressprofil oder als Druckgussgehäuse ausgeführt sein. Als Gehäusematerial kommen Metalle wie beispielsweise Aluminium, Stahl, Edelstahl oder Zink in Frage, wobei zusätzlich eine Beschichtung des Gehäuses 11 beziehungsweise Modulgehäuses 110 vorgesehen sein kann. Insbesondere bei einer metallischen Ausgestaltung des Modulgehäuses 110 kann es vorgesehen sein, dass die Modulgehäuseseite 111 eben ist. Es kann vorgesehen sein, dass das Modulgehäuse 110 dann weitere, nicht-metallische Elemente beinhaltet, die nicht notwendigerweise eben sein müssen, beziehungsweise aus dem Modulgehäuse 110 herausragen können. Ebenso kann es vorgesehen sein, dass die Gehäuseseite 12 eben ist.

Das Gehäuse 11 beziehungsweise das Modulgehäuse 110 kann dabei aus mehreren Einzelteilen bestehen, die mittels Befestigungselementen, beispielsweise Schrauben, oder mittels verschweißen oder verlöten miteinander verbunden werden. Ferner kann eine Abdichtung zwischen den Einzelteilen vorgesehen sein, um das Gehäuse 11 beziehungsweise das Modulgehäuse 110 zwischen den Einzelteilen für Flüssigkeiten und/oder Berührungen unzugänglich zu machen.

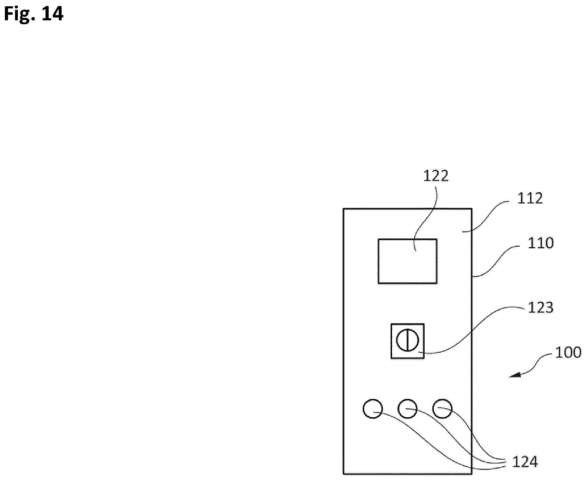

Fig. 14 zeigt eine Draufsicht auf ein Funktionsmodul 100, welches einem der bereits beschriebenen Funktionsmodule 100 entsprechen kann. Das Modulgehäuse 100 weist auf einer weiteren Modulgehäuseseite 112 ein Anzeigeelement 122, ein Regelelement 123 sowie mehrere Peripherieanschlusselemente 124 auf. Das Anzeigeelement 122 kann eingerichtet sein, einen oder mehrere Mess- beziehungsweise Systemwerte anzuzeigen. Über das Regelelement 123 kann eine Regeleingabe erfolgen. Die Peripherieanschlusselemente 124 können zum Anschluss von Sensoren, Aktoren, Motoren oder zur Ausgabe einer Spannung oder eines Stromes dienen. Das Funktionsmodul 100 kann eine beliebige Kombination von Anzeigeelement 122, Regelelement 123 und Peripherieanschlusselementen 124 aufweisen, insbesondere können Anzeigeelement 122 und/oder Regelelement 123 weggelassen sein beziehungsweise kein oder eine andere Anzahl von Peripherieanschlusselementen 124 vorgesehen sein.

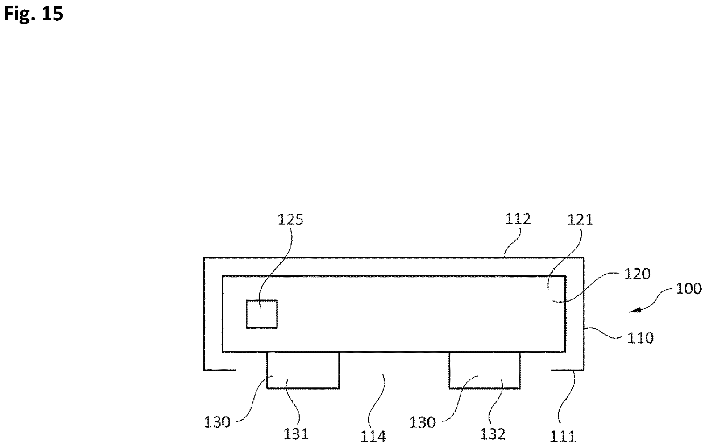

Fig. 15 zeigt einen Querschnitt durch ein Funktionsmodul 100, welches dem Funktionsmodul 100 der Fig. 5 entspricht, sofern im Folgenden keine Unterschiede beschrieben sind. An der Modulgehäuseseite 111 ist ein Teil des Modulgehäuses 110 angeordnet, die Modulgehäuseöffnung 114 deckt nicht die gesamte Modulgehäuseseite 111 ab. Zusätzlich ist auf der Modulleiterkarte 121 ein Speicherchip 125 angeordnet, der als EEPROM ("electrically erasable programmable read-only memory", elektrisch löschbarer programmierbarer Nur-Lese-Speicher) ausgeführt sein kann. Auf dem Speicherchip 125 können Informationen darüber hinterlegt sein, um welchen Typ des Funktionsmodules 100 es sich bei dem Funktionsmodul 100 handelt und welche Kommunikation über den Feldbus mit dem Funktionsmodul 100 möglich ist. Diese Informationen können auf dem Speicherchip 125 auch dann hinterlegt sein, wenn das Funktionsmodul 100 nicht an ein Basismodul angeschlossen ist. Dadurch ist es möglich, das Funktionsmodul 100 im laufenden Betrieb an das Basismodul anzustecken beziehungsweise zu entfernen, ohne dass der Betrieb des Systems aus Basismodul und weiteren Funktionsmodulen unterbrochen werden muss. Dadurch kann beispielsweise eine ausgelöste Sicherung im Funktionsmodul 100 ersetzt werden, indem das entsprechende Funktionsmodul 100 vom Basismodul entfernt wird und anschließend nach dem Ersetzen der Sicherung wieder am Basismodul angebracht wird. Durch den Speicherchip 125 kann das Funktionsmodul nach dem Wiederanbringen wieder in den Feldbus integriert werden.

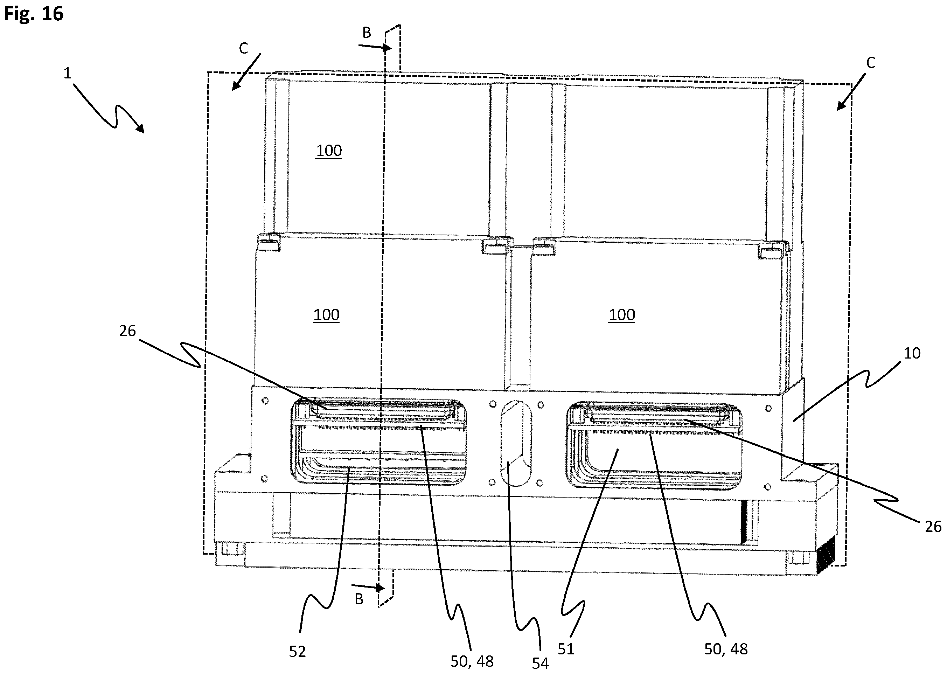

Fig. 16 zeigt einen Querschnitt durch ein weiteres Schaltschranksystem 1, bestehend aus einem Basismodul 10 und drei Funktionsmodulen 100. Das Basismodul 10 entspricht dabei dem Basismodul 10 der Fig. 13 sofern im Folgenden keine Unterschiede beschrieben sind. Eine Schnittebene des Querschnitts ist dabei außerhalb der Funktionsmodule 100 angeordnet, so dass nur das Basismodul 10 im Querschnitt geöffnet ist. Das Basismodul 10 weist zwei Kanäle, also einen ersten Kanal 51 und einen zweiten Kanal 52 auf. Sowohl im ersten Kanal 51 als auch im zweiten Kanal 52 weist das Basismodul 10 eine Daten- und Kleinspannungsleiterkarte 48 und jeweils ein auf der Daten- und Kleinspannungsleiterkarte 48 angeordnetes erstes Anschlusselement 26 auf. Die direkt hinter der Schnittebene liegenden Funktionsmodule 100 greifen jeweils in die ersten Anschlusselemente 26 ein und überdecken jeweils den ersten Kanal 51 oder den zweiten Kanal 52. An anderer Stelle kann im zweiten Kanal 52 eine Niederspannungsleiterkarte vorgesehen sein, die wie in den Fig. 13 beschrieben ausgestaltet sein kann. Hinter den direkt nach der Schnittebene angeordneten Funktionsmodulen 100 ist ein Funktionsmodul 100 angeordnet, welches den ersten Kanal 51 und den zweiten Kanal 52 überdeckt.

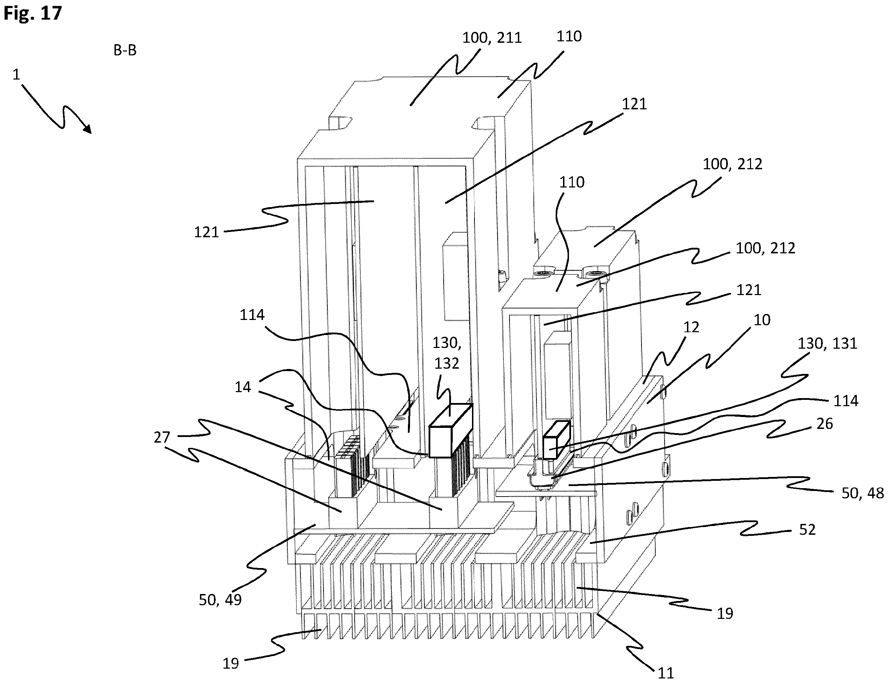

Fig. 17 zeigt einen Querschnitt durch das Schaltschranksystem 1 der Fig. 16 an der mit B bezeichneten Schnittebene. Modulleiterkarten 121 eines ersten Funktionsmoduls 211 weisen eine elektronische Schaltung auf, die Niederspannung benötigt. Folglich greift im Bereich des ersten Funktionsmoduls 211 ein Modulanschlusselement 130, welches in Form eines zweiten Steckelements 132 ausgestaltet ist, in ein zweites Anschlusselement 27 des Basismoduls 10 ein. Das zweite Anschlusselement 27 ist dabei auf einer Leiterkarte 50, die als Niederspannungsleiterkarte 49 ausgeführt ist, angeordnet. Die in einem zweiten Funktionsmodul 212 auf einer Modulleiterkarte 121 verbaute elektronische Schaltung benötigt keine Niederspannung. Ferner ist das zweite Funktionsmodul 212 nur oberhalb des zweiten Kanals 52 angeordnet. Das zweite Funktionsmodul 212 weist ein erstes Steckelement 131 auf, welches in ein erstes Anschlusselement 26 der bereits in Fig. 16 gezeigten Daten- und Kleinspannungsleiterkarte 48 eingreift.

Ebenso in Fig. 17 dargestellt sind Kühlelemente 19, die am Gehäuse 11 des Basismoduls 10 in der Form von Kühlrippen angeordnet sind und einen Wärmeaustausch mit der Umgebung ermöglichen.

Die Modulleiterkarten 121 sind senkrecht zur ersten Gehäuseseite 12 angeordnet. Es sind jedoch auch andere Anordnungen der Modulleiterkarten 121 möglich. Die Daten- und Kleinspannungsleiterkarte 48 sowie die Niederspannungsleiterkarte 49 ist jeweils parallel zur ersten Gehäuseseite 12 angeordnet.

Das erste Anschlusselement 26 der Daten- und Kleinspannungsleiterkarte 48 ist dabei innerhalb des Gehäuses 11 des Basismoduls 10 angeordnet. Das erste Steckelement 131 ist durch die Modulgehäuseöffnung 114 vom Inneren des Modulgehäuses 110 zum Äußeren des Modulgehäuses 110 geführt. Die zweiten Anschlusselemente 27 sind ebenfalls innerhalb des Gehäuses 11 des Basismoduls 10 angeordnet. Das zweite Steckelement 132 ist analog zum ersten Steckelement 131 durch die Modulgehäuseöffnung 114 vom Inneren des Modulgehäuses 110 zum Äußeren des Modulgehäuses 110 geführt.

In einem alternativen, nicht dargestellten Ausführungsbeispiel können die zweiten Anschlusselemente 27 der Niederspannungsleiterkarte 49 durch eine Öffnung 14 des Gehäuses 11 des Basismoduls 10 geführt sein und über die Gehäuseseite 12 hinausragen. Das zweite Steckelement 132 kann dann innerhalb des Modulgehäuses 110 angeordnet sein oder ebenfalls analog zum ersten Steckelement 131 durch die Modulgehäuseöffnung 114 vom Inneren des Modulgehäuses 110 zum Äußeren des Modulgehäuses 110 geführt sein.

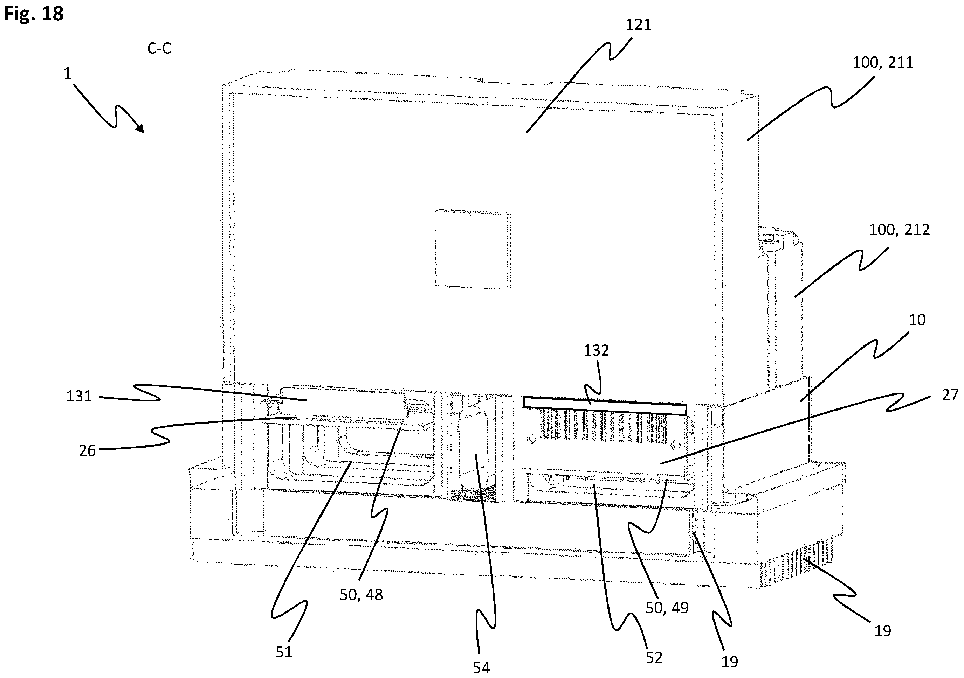

Fig. 18 zeigt einen Querschnitt durch das Schaltschranksystem 1 der Fig. 16 an der mit C bezeichneten Schnittebene . Ein erstes Steckelement 131 greift in das erste Anschlusselement 26 ein. Das in Fig. 17 dargestellte zweite Steckelement 132 dient zum Eingriff in das zweite Anschlusselement 27.

In den Fig. 16 bis 18 ist also ein Schaltschranksystem 1 gezeigt, welches im zweiten Kanal 52 sowohl erste Anschlusselemente 26 auf einer Daten- und Kleinspannungsleiterkarte 48 als auch zweite Anschlusselemente 27 auf einer Niederspannungsleiterkarte 49 aufweist.

Die ersten Anschlusselemente 26 können dabei so ausgestaltet sein, dass sie Gegenstücke zu dem in Fig. 6 gezeigten ersten Steckelement 131 bilden.

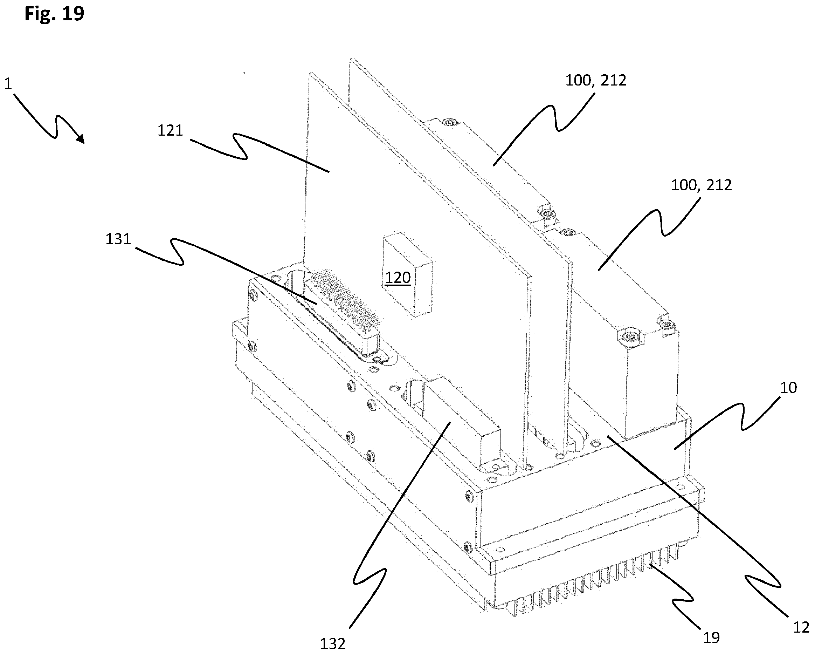

Fig. 19 zeigt eine gedrehte isometrische Ansicht des Schaltschranksystems 1 der Fig. 16 bis 18, bei dem das Modulgehäuse des ersten Funktionsmoduls entfernt wurde. Die elektronische Schaltung 120 auf der Modulleiterkarte 121 weist ein erstes Steckelement 131 zum Eingriff in das erste Anschlusselement und ein zweites Steckelement 132 zum Eingriff in das zweite Anschlusselement auf. Die Anschlusselemente sind dabei durch das erste Steckelement 131 beziehungsweise das zweite Steckelement 132 verdeckt. Die Modulleiterkarte 121 ist senkrecht zur ersten Gehäuseseite 12 angeordnet. Es sind jedoch auch andere Anordnungen der Modulleiterkarten 121 möglich. Das erste Funktionsmodul weist dabei zwei Modulleiterkarten 121 auf, es ist jedoch auch eine andere Anzahl von Modulleiterkarten 121 denkbar.

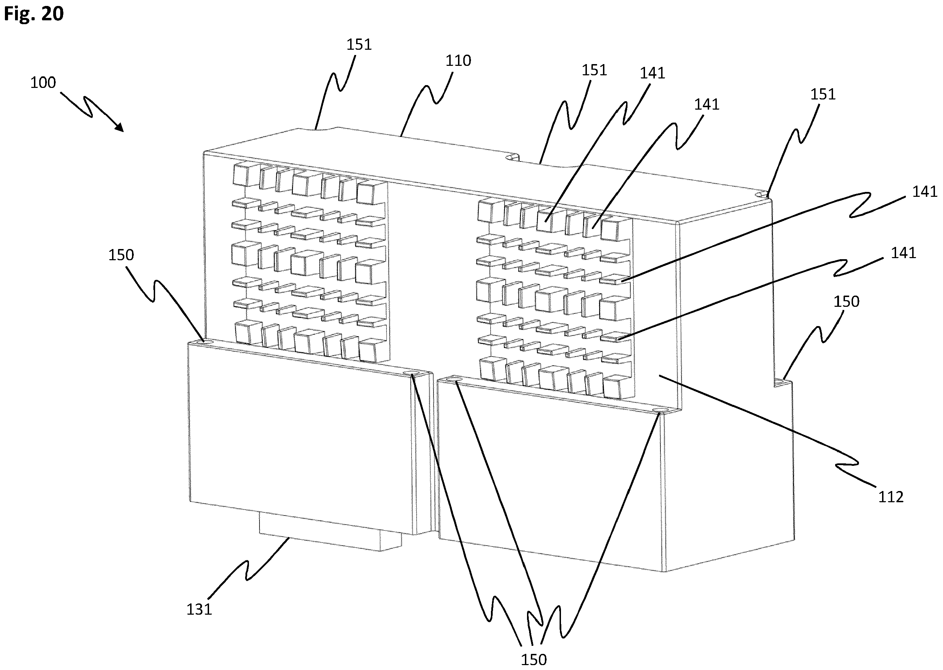

Fig. 20 zeigt eine isometrische Ansicht eines Funktionsmoduls 100 mit Stabkühlkörpern 141. Das Funktionsmodul 100 weist ein erstes Steckelement 131 auf, welches zur Verbindung des Funktionsmoduls 131 mit einem Basismodul genutzt werden kann. Die Stabkühlkörper 141 sind an einer weiteren Modulgehäuseseite 112 angeordnet. Ferner weist das Modulgehäuse 110 Durchgangslöcher 150 und Ausnehmungen 151 analog zu Fig. 10 auf, die der Befestigung des Funktionsmoduls 100 an einem Basismodul mittels Schrauben dienen können.

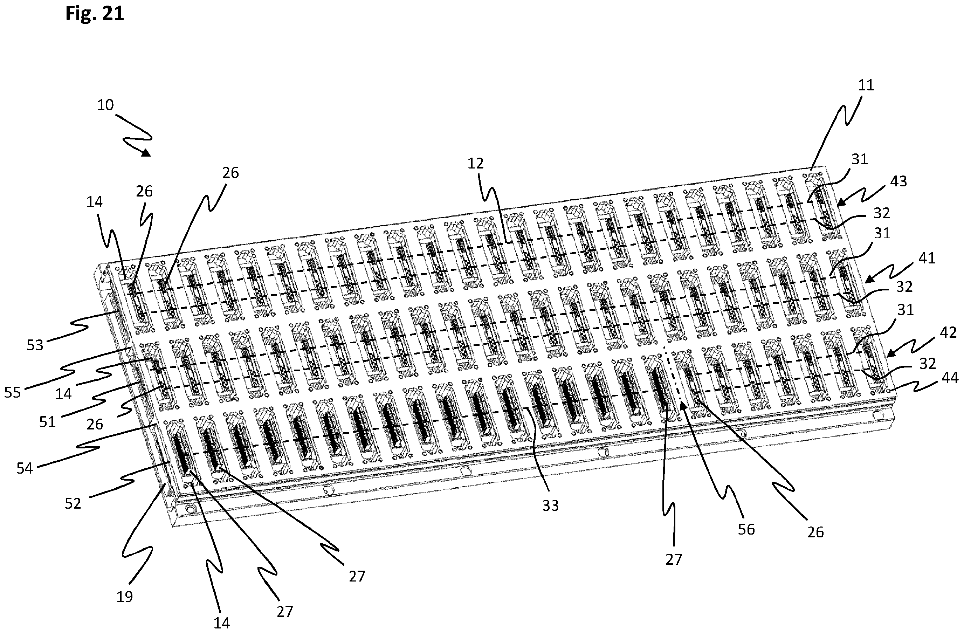

Fig. 21 zeigt eine isometrische Ansicht eines Basismoduls 10 für ein Schaltschranksystem. Das Basismodul 10 weist eine erste Reihe 41, eine zweite Reihe 42 sowie eine dritte Reihe 43 von Öffnungen 14 auf. Der ersten Reihe 41 ist in einem Inneren eines Gehäuses 11 des Basismoduls 10 ein erster Kanal 51 zugeordnet. Der zweiten Reihe 42 ist im Inneren des Gehäuses 11 ein zweiter Kanal 52 zugeordnet. Der dritten Reihe 43 ist im Inneren des Gehäuses 11 ein dritter Kanal 53 zugeordnet. Die erste Reihe 41 von Öffnungen 14 ist mittig angeordnet, die zweite Reihe 42 und die dritte Reihe 43 von Öffnungen 14 sind auf gegenüberliegenden Seiten der ersten Reihe 41 angeordnet. Der erste Kanal 51 ist also ebenfalls mittig, zwischen dem zweiten Kanal 52 und dem dritten Kanal 53 angeordnet. Eine erste Trennwand 54 und eine zweite Trennwand 55 grenzen an den ersten Kanal 51 an, wobei die erste Trennwand 54 den ersten Kanal 51 vom zweiten Kanal 52 trennt und die zweite Trennwand 55 den ersten Kanal 51 vom dritten Kanal 53 trennt.

Im ersten Kanal 51 und im dritten Kanal 53 sind erste Anschlusselemente 26 angeordnet. Im zweiten Kanal 52 sind zweite Anschlusselemente 27 angeordnet. Es ist jedoch im nicht vorgesehen, dass allen Öffnungen 14 der zweiten Reihe 42 jeweils ein zweites Anschlusselement 27 zugeordnet ist. Die zweiten Anschlusselemente 27 sind im zweiten Kanal 52 nur bis zu einer Grenze 56 angeordnet. Die Grenze ist in Fig. 21 mittels einer Strich-Punkt-Linie verdeutlicht. Im Bereich der verbleibenden Öffnungen 14 der zweiten Reihe 42 sind im zweiten Kanal 52 analog zum ersten Kanal 51 erste Anschlusselemente 26 angeordnet. Mit einer solchen Anordnung können unterschiedliche Anforderungen an ein Schaltschranksystem aus Basismodul 10 und Funktionsmodulen 100 erfüllt werden und dabei gleichzeitig eine bessere Ausnutzung der durch das Basismodul 10 bereitgestellten Steckplätze für Funktionsmodule realisiert werden. Die zweiten Anschlusselemente 27 sind mit einer gestrichelt dargestellten Niederspannungsleitung 33 verbunden. Die ersten Anschlusselemente sind mit einer ebenfalls gestrichelt dargestellten Datenleitung 31 sowie einer gestrichelt dargestellten Kleinspannungsleitung 22 verbunden.

Zusätzlich kann vorgesehen sein, dass Kühlluft durch den dritten Kanal 53 geführt wird. Alternativ oder zusätzlich können auch der erste Kanal 51 und/oder der zweite Kanal 52 zum Führen von Kühlluft genutzt werden.

Unterhalb der ersten bis dritten Kanäle 51, 52, 53 sind Kühlelemente 19 angeordnet. Diese sind als Kühlrippen ausgestaltet, können jedoch auch eine andere Form aufweisen. Die Kühlelemente 19 können zum Wärmetransport vom Inneren des Gehäuses 11 in die Umgebung eingerichtet sein. Um die Öffnungen 14 sind Gewindelöcher 44 angeordnet, die der Befestigung von Funktionsmodulen am Basismodul 10 dienen können. Die Gewindelöcher 44 können dabei als Sacklöcher ausgeführt sein.

Die Datenleitung 31 kann eingerichtet sein, einen Feldbus über alle ersten Anschlusselemente 26 bereitzustellen.

Die ersten Anschlusselemente 26 können unterhalb der Öffnungen 14 angeordnet sein. Die zweiten Anschlusselemente 27 können ebenfalls unterhalb der Öffnungen 14 angeordnet sein. Alternativ können die zweiten Anschlusselemente 27 durch die Öffnungen 14 geführt und damit auch teilweise oberhalb der ersten Seite 12 angeordnet sein.

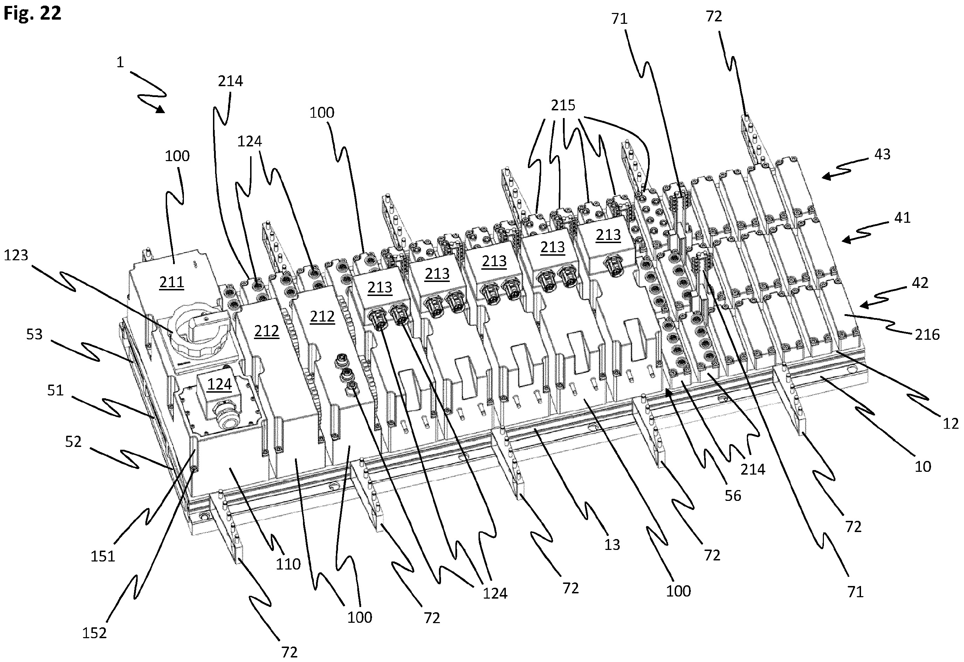

Fig. 22 zeigt ein Schaltschranksystem 1 bestehend aus dem Basismodul 10 der Fig. 21 sowie mehreren Funktionsmodulen 100. Die Funktionsmodule 100 sind dabei unterschiedlich groß und decken eine unterschiedliche Anzahl von Öffnungen ab. Ferner sind Deckel 216 oberhalb von Öffnungen ohne Funktionsmodulen 100 angeordnet. Die Funktionsmodule 100 können wie in Fig. 13 beziehungsweise 16 bis 19 gezeigt mit dem Basismodul 10 verbunden werden.

Bis zur Grenze 56 in den Bereichen, in denen im zweiten Kanal 52 Niederspannungsanschlüsse angeordnet sind, überdecken die Funktionsmodule 100 sowohl den ersten Kanal 51 als auch den zweiten Kanal 52. Ein erstes Funktionsmodul 211 in diesem Bereich überdeckt zusätzlich auch den dritten Kanal 53, während zweite Funktionsmodule 212 und dritte Funktionsmodule 213 nur den ersten Kanal 51 und den zweiten Kanal 52 überdecken. Vierte Funktionsmodule 214 und fünfte Funktionsmodule 215 überdecken jeweils nur einen der ersten bis dritten Kanäle 51, 52, 53. Der dritte Kanal 53 ist dabei außer vom ersten Funktionsmodul 211 nur von vierten Funktionsmodulen 214 und fünften Funktionsmodulen 215 überdeckt. Der erste Kanal 51 und der der zweite Kanal 52 sind ab der Grenze 56 von den vierten Funktionsmodulen 214 überdeckt, also in Bereichen, in denen im zweiten Kanal 52 erste Anschlusselemente angeordnet sind. Dadurch steht für jedes Funktionsmodul 100 mindestens ein erstes Anschlusselement zur Verfügung, wodurch alle Funktionsmodule 100 an die Datenleitung des Basismoduls 10 angeschlossen werden können.

Das erste Funktionsmodul 211 weist dabei sowohl ein Regelelement 123 als auch ein Peripherieanschlusselement 124 auf. Die weiteren zweiten bis fünften Funktionsmodule 212, 213, 214, 215 weisen keine Regelelemente 123 und nur teilweise Peripherieanschlusselemente 124 auf. Mittels Schrauben 152, die in Ausnehmungen 151 der Modulgehäuse 110 angeordnet sind, werden die Funktionsmodule 100 an dem Basismodul 10 befestigt. Die Schrauben 152 greifen dabei in die in Fig. 21 gezeigten Gewindelöcher 44 ein.

Auf der ersten Gehäuseseite 12 des Basismoduls 10 sind erste Kabelführungselemente 71 angeordnet, die dem geordneten Führen von an die Peripherieanschlusselemente 124 angeschlossenen, nicht dargestellten Kabeln dienen. Auf weiteren Gehäuseseiten 13 sind zweite Kabelführungselemente 72 angeordnet, die ebenfalls dem geordneten Führen von an die Peripherieanschlusselemente 124 angeschlossenen, nicht dargestellten Kabeln dienen.

Da alle Öffnungen des Basismoduls 10 mittels der Funktionsmodule 100 beziehungsweise der Deckel 216 verschlossen sind, ist das Schaltschranksystem 1 flüssigkeitsdicht und staubdicht ausgestaltet.

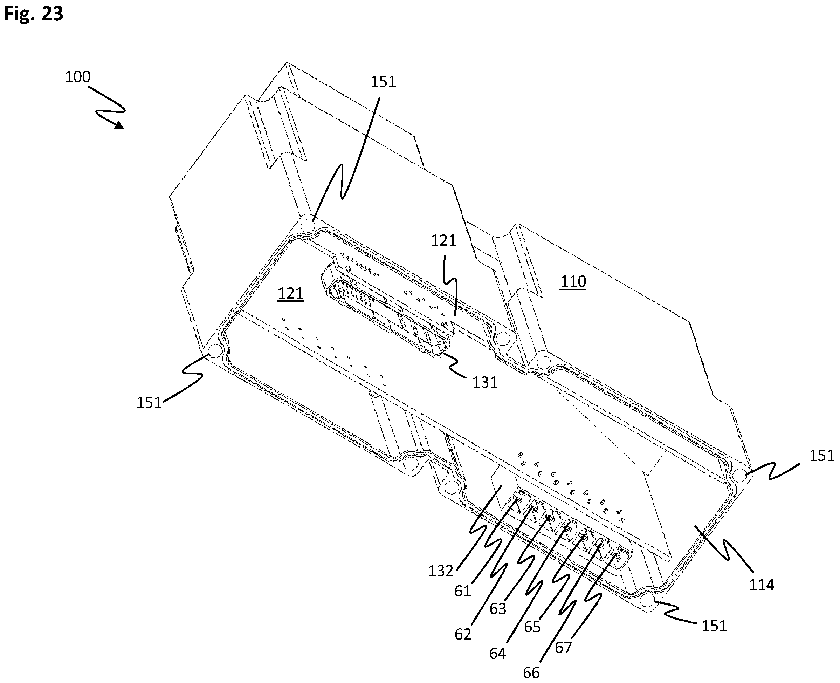

Fig. 23 zeigt eine isometrische Ansicht von unten auf ein Funktionsmodul 100, welches dem ersten Funktionsmodul 211 der Fig. 16 bis 19 entspricht, sofern im Folgenden keine Unterschiede beschrieben sind. Das erste Steckelement 131 ist wie in Fig. 6 gezeigt ausgestaltet. Das zweite Steckelement 132 weist einen ersten Kontakt 61, einen zweiten Kontakt 62 und einen dritten Kontakt 63 für jeweils eine Wechselstromphase eines Dreiphasenwechselstroms auf. Ferner weist zweite Steckelement 132 einen vierten Kontakt 64 für einen Wechselstromneutralleiter, einen fünften Kontakt 65 für einen Schutzleiter sowie einen sechsten Kontakt 66 und einen siebten Kontakt 67 für eine Gleichspannung auf. Abhängig von der vom Funktionsmodul 100 benötigten Spannungsversorgung kann das zweite Steckelement 132 den ersten Kontakt 61, den zweiten Kontakt 62, den dritten Kontakt 63, den vierten Kontakt 64 und den fünften Kontakt 65 aufweisen, wenn vom Funktionsmodul 100 eine Dreiphasenwechselspannung benötigt wird. Wird nur eine Phase der Wechselspannung benötigt, kann neben dem vierten Kontakt 64 und dem fünften Kontakt 65 nur der erste Kontakt 61 oder der zweite Kontakt 62 oder der dritte Kontakt 63 im zweiten Steckelement 132 vorgesehen sein. Falls das Funktionsmodul 100 eine Gleichspannung benötigt, kann das zweite Steckelement 132 den fünften Kontakt 65, den sechsten Kontakt 66 sowie den siebten Kontakt 67 aufweisen. Wenn sowohl Gleichspannung als auch Wechselspannung vom Funktionsmodul 100 benötigt werden, können die entsprechenden Kontakte vorgesehen sein, insbesondere alle ersten bis siebten Kontakte 61, 62, 63, 64, 65, 66, 67, falls alle drei Wechselstromphasen verwendet werden, oder der vierte Kontakt 64, der fünfte Kontakt 65, der sechste Kontakt 66, der siebte Kontakt 67 sowie in der erste Kontakt 61 oder der zweite Kontakt 62 oder der dritte Kontakt 63, falls nur eine der drei Wechselstromphasen verwendet wird.

Die in den Fig. 6 und 23 gezeigte Anordnung der ersten Stecckontakte 171 beziehungsweise zweiten Steckkontakte 172 des ersten Steckelements 131 beziehungsweise der ersten bis siebten Kontakte 61, 62, 63, 64, 65, 66, 67 des zweiten Steckelements 132 können auch anders angeordnet werden.

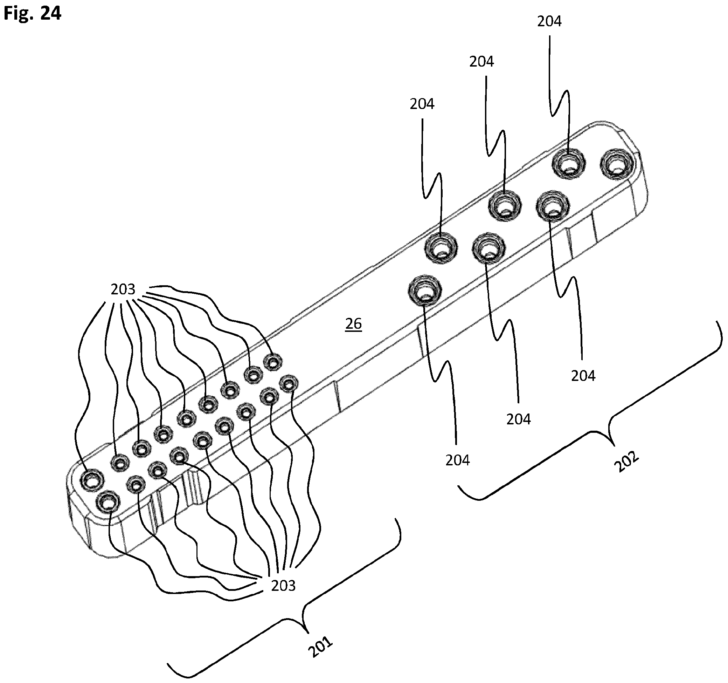

Fig. 24 zeigt eine isometrische Ansicht eines ersten Anschlusselements 26. Das in den Fig. 13, 16 bis 19 und 21 sowie 22 dargestellte erste Anschlusselement 26 kann beispielsweise wie in Fig. 24 dargestellt ausgestaltet sein. Das erste Anschlusselement 26 ist derart ausgestaltet, dass das erste Steckelement 131 der Fig. 6 und 23 in das erste Anschlusselement 26 eingesteckt werden kann. In einem dritten Bereich 201 weist das erste Anschlusselement 26 dritte Steckkontakte 203 auf, die zu den ersten Steckkontakten 171 des ersten Steckelements 131 korrespondierend angeordnet sind. In einem vierten Bereich 202 weist das erste Anschlusselement 26 vierte Steckkontakte 204 auf, die zu den zweiten Steckkontakten 172 des ersten Steckelements 131 korrespondierend angeordnet sind. Die dritten Steckkontakte 203 dienen also der Übertragung von Daten, während die vierten Steckkontakte 204 der Übertragung von Kleinspannung dienen.

### Bezugszeichenliste

- 1: System
- 2: gemeinsames Gehäuse
- 3: Zwischenraum

- 10: Basismodul
- 11: Gehäuse
- 12: Gehäuseseite
- 13: weitere Gehäuseseite
- 14: Öffnung

- 21: Datenanschluss
- 22: Kleinspannungsanschluss
- 23: Niederspannungsanschluss
- 26: erstes Anschlusselement
- 27: zweites Anschlusselement

- 31: Datenleitung
- 32: Kleinspannungsleitung
- 33: Niederspannungsleitung

- 44: Gewindeloch
- 48: Daten- und Kleinspannungsleiterkarte
- 49: Niederspannungsleiterkarte

- 50: Leiterkarte
- 51: erster Kanal
- 52: zweiter Kanal
- 54: Trennwand

- 61: erster Kontakt
- 62: zweiter Kontakt
- 63: dritter Kontakt
- 64: vierter Kontakt
- 65: fünfter Kontakt
- 66: sechster Kontakt
- 67: siebter Kontakt
- 100: Funktionsmodul
- 110: Modulgehäuse
- 111: Modulgehäuseseite
- 112: weitere Modulgehäuseseite
- 114: Modulgehäuseöffnung
- 115: Vorsprung
- 116: Führungsnut
- 117: Abdeckung
- 118: Befestigungsmittel

- 120: elektronische Schaltung
- 121: Modulleiterkarte
- 122: Anzeigeelement
- 123: Regelelement
- 124: Peripherieanschlusselement
- 125: Speicherchip

- 130: Modulanschlusselement
- 131: erstes Steckelement
- 132: zweites Steckelement
- 133: Stecker
- 134: Schutzgehäuse

- 141: Stabkühlkörper
- 142: Strangkühlkörper
- 143: Teilbereich
- 150: Durchgangsloch
- 151: Ausnehmung
- 160: Sicherung

- 168: erster Bereich
- 169: zweiter Bereich

- 171: erster Steckkontakt
- 172: zweiter Steckkontakt
- 173: erster Kommunikationsspannungskontakt
- 174: zweiter Kommunikationsspannungskontakt
- 175: erster Kommunikationskanal
- 176: zweiter Kommunikationskanal

- 181: erstes Datenanschlusselement
- 182: zweites Datenanschlusselement
- 183: drittes Datenanschlusselement
- 184: viertes Datenanschlusselement
- 185: fünftes Datenanschlusselement
- 186: sechstes Datenanschlusselement

- 191: erster Gleichspannungskontakt
- 192: zweiter Gleichspannungskontakt
- 193: dritter Gleichspannungskontakt
- 194: vierter Gleichspannungskontakt
- 195: fünfter Gleichspannungskontakt
- 196: sechster Gleichspannungskontakt
- 197: Schutzleiterkontakt

- 201: dritter Bereich
- 202: vierter Bereich
- 203: dritte Steckkontakte
- 204: vierte Steckkontakte

- 211: erstes Funktionsmodul
- 212: zweites Funktionsmodul
- 213: drittes Funktionsmodul
- 214: viertes Funktionsmodul
- 215: fünftes Funktionsmodul
- 216: Deckel

## Patentansprüche

1. Schaltschranksystem (1) aus einem Basismodul (10) und mehreren Funktionsmodulen (100), wobei das Basismodul (10) ein Gehäuse (11) mit einer Gehäuseseite (12) und Öffnungen (14) der Gehäuseseite (12), erste Anschlusselemente (26) und zweite Anschlusselemente (27) aufweist, wobei die ersten Anschlusselemente (26) Datenanschlüsse (21) und Kleinspannungsanschlüsse (22) bereitstellen, wobei die zweiten Anschlusselemente (27) Niederspannungsanschlüsse (23) bereitstellen, wobei die ersten Anschlusselemente (26) innerhalb des Gehäuses (11) im Bereich von Öffnungen (14) angeordnet sind, wobei die Datenanschlüsse (21) mit einer Datenleitung (31) verbunden sind, wobei die Kleinspannungsanschlüsse (22) mit einer Kleinspannungsleitung (32) verbunden sind, wobei die Niederspannungsanschlüsse (23) mit einer Niederspannungsleitung (33) verbunden sind, wobei über die Kleinspannungsleitung (32) und die Kleinspannungsanschlüsse (22) eine Kleinspannung bis zu 50 Volt Wechselspannung und/oder 120 Volt Gleichspannung bereitgestellt werden kann und über die Niederspannungsleitung (33) und die Niederspannungsanschlüsse (23) eine Niederspannung oberhalb der Kleinspannung und bis zu 1000 Volt Wechselspannung und/oder 1500 Volt Gleichspannung bereitgestellt werden kann, wobei die Funktionsmodule (100) jeweils ein Modulgehäuse (110), eine elektronische Schaltung (120) und einem Modulanschlusselement (130) aufweisen, wobei das Modulanschlusselement (130) mit der elektronischen Schaltung (120) verbunden ist, wobei das Modulgehäuse (110) eine Modulgehäuseseite (111) aufweist, wobei die Modulgehäuseseite (111) eine Modulgehäuseöffnung (114) aufweist, wobei das Modulanschlusselement (130) ein erstes Steckelement (131) umfasst, wobei sich das erste Steckelement (131) durch die Modulgehäuseöffnung (114) vom Inneren des Modulgehäuses (110) zum Äußeren des Modulgehäuses (110) erstreckt und eingerichtet ist, in die ersten Anschlusselemente (26) des Basismoduls (10) einzugreifen, wobei bei mindestens einem Funktionsmodul (100) das Modulanschlusselement (130) ein zweites Steckelement (132) umfasst, wobei das zweite Steckelement (132) eingerichtet ist, in die zweiten Anschlusselemente (27) des Basismoduls (10) einzugreifen, **dadurch gekennzeichnet, dass** das erste Steckelement (131) zumindest in einen ersten Bereich (168) und einen zweiten Bereich (169) unterteilt ist, dass erste Steckkontakte (171) zum Übertragen von Daten im ersten Bereich (168) angeordnet sind und dass zweite Steckkontakte (172) zum Übertragen von Kleinspannung im zweiten Bereich (169) angeordnet sind, dass das erste Anschlusselement (26) in zumindest einen dritten Bereich (201) und einen vierten Bereich (202) unterteilt ist, dass im dritten Bereich (201) dritte Steckkontakte (203) zum Übertragen von Daten und im vierten Bereich (202) vierte Steckkontakte (204) zum Übertragen von Kleinspannung angeordnet sind, dass die ersten Steckkontakte (171) mit den dritten Steckkontakten (203) verbunden werden können und dass die zweiten Steckkontakte (172) mit den vierten Steckkontakten (204) verbunden werden können, dass die ersten Steckkontakte (171) und die zweiten Stecckontakte (172) unterschiedlich ausgestaltet sind, und dass die ersten Anschlusselemente (26) und die zweiten Anschlusselemente (27) beabstandet voneinander angeordnet sind.

2. Schaltschranksystem (1) nach Anspruch 1, wobei sich die zweiten Anschlusselemente (27) im Inneren des Gehäuses (11) angeordnet sind und wobei sich das zweite Steckelement (132) durch die Modulgehäuseöffnung (114) vom Inneren des Modulgehäuses (110) zum Äußeren des Modulgehäuses (110) erstreckt.

3. Schaltschranksystem (1) nach einem der Ansprüche 1 oder 2, wobei die ersten Steckkontakte (171) beziehungsweise die dritten Steckkontakte (203) zumindest einen ersten Kommunikationsspannungskontakt (175), einen zweiten Kommunikationsspannungskontakt (176), ein erstes Datenanschlusselement (181), ein zweites Datenanschlusselement (182), ein drittes Datenanschlusselement (183), ein viertes Datenanschlusselement (184), ein fünftes Datenanschlusselement (185) und ein sechstes Datenanschlusselement (186) umfassen.

4. Schaltschranksystem nach einem der Ansprüche 1 bis 3, wobei die zweiten Steckkontakte (172) beziehungsweise die vierten Steckkontakte (204)zumindest einen ersten Gleichspannungskontakt (191), einen zweiten Gleichspannungskontakt (192), einen dritten Gleichspannungskontakt (193), einen vierten Gleichspannungskontakt (194), einen fünften Gleichspannungskontakt (195), einen sechsten Gleichspannungskontakt (196) sowie einen Schutzleiterkontakt (197) umfassen.

5. Schaltschranksystem (1) nach einem der Ansprüche 1 bis 4, wobei das Schaltschranksystem (1) flüssigkeits- und staubdicht ausgestaltet ist.

6. Funktionsmodul (100) mit einem Modulgehäuse (110), einer elektronischen Schaltung (120) und einem Modulanschlusselement (130), wobei das Modulanschlusselement (130) mit der elektronischen Schaltung (120) verbunden ist, wobei das Modulgehäuse (110) eine Modulgehäuseseite (111) aufweist, wobei die Modulgehäuseseite (111) eine Modulgehäuseöffnung (114) aufweist, wobei das Modulanschlusselement (130) ein erstes Steckelement (131) umfasst, wobei sich das erste Steckelement (131) durch die Modulgehäuseöffnung (114) vom Inneren des Modulgehäuses (110) zum Äußeren des Modulgehäuses (110) erstreckt und eingerichtet ist, in ein erstes Anschlusselement (26) eines Basismoduls (10) einzugreifen, wobei das Modulanschlusselement (130) ein zweites Steckelement (132) umfasst, wobei das zweite Steckelement (132) eingerichtet ist, in die zweiten Anschlusselemente (27) des Basismoduls (10) einzugreifen, **dadurch gekennzeichnet, dass** das erste Steckelement (131) zumindest in einen ersten Bereich (168) und einen zweiten Bereich (169) unterteilt ist, dass erste Steckkontakte (171) zum Übertragen von Daten im ersten Bereich (168) angeordnet sind und dass zweite Stecckontakte (172) zum Übertragen von Kleinspannung im zweiten Bereich (169) angeordnet sind, dass die ersten Steckkontakte (171) mit dritten Steckkontakten (203) des ersten Anschlusselements (26) des Basismoduls (10) verbunden werden können und dass die zweiten Steckkontakte (172) mit vierten Steckkontakten (204) des ersten Anschlusselements (26) des Basismoduls (10) verbunden werden können, dass die ersten Steckkontakte (171) und die zweiten Steckkontakte (172) unterschiedlich ausgestaltet sind, und dass das erste Steckelement (131) und das zweite Steckelement (132) beabstandet voneinander angeordnet sind.

7. Funktionsmodul (100) nach Anspruch 6, wobei sich das zweite Steckelement (132) durch die Modulgehäuseöffnung (114) vom Inneren des Modulgehäuses (110) zum Äu-ßeren des Modulgehäuses (110) erstreckt.

8. Funktionsmodul (100) nach einem der Ansprüche 6 oder 7, wobei das Modulgehäuse (110) ein Metall aufweist, insbesondere aus einem Metall besteht, wobei das Metall insbesondere Aluminium und/oder Zink aufweist.

9. Funktionsmodul (100) nach einem der Ansprüche 6 bis 8, wobei das Modulgehäuse (110) aus einem Stangenpressprofil besteht oder ein Druckgussgehäuse ist.

10. Funktionsmodul (100) nach einem der Ansprüche 6 bis 9, ferner aufweisend eine Sicherung (160), wobei die Sicherung (160) zwischen dem Modulanschlusselement (130) und der elektronischen Schaltung (120) angeordnet ist.

11. Basismodul (10) für ein Schaltschranksystem (1), wobei das Basismodul (10) ein Gehäuse (11) mit einer Gehäuseseite (12) und Öffnungen (14) der Gehäuseseite (12), erste Anschlusselemente (26) und zweite Anschlusselemente (27) aufweist, wobei die ersten Anschlusselemente (26) Datenanschlüsse (21) und Kleinspannungsanschlüsse (22) bereitstellen, wobei die zweiten Anschlusselemente (27) Niederspannungsanschlüsse (23) bereitstellen, wobei die ersten Anschlusselemente (26) innerhalb des Gehäuses (11) im Bereich von Öffnungen (14) angeordnet sind, wobei die Datenanschlüsse (21) mit einer Datenleitung (31) verbunden sind, wobei die Kleinspannungsanschlüsse (22) mit einer Kleinspannungsleitung (32) verbunden sind, wobei die Niederspannungsanschlüsse (23) mit einer Niederspannungsleitung (33) verbunden sind, wobei über die Kleinspannungsleitung (32) und die Kleinspannungsanschlüsse (22) eine Kleinspannung bis zu 50 Volt Wechselspannung und/oder 120 Volt Gleichspannung bereitgestellt werden kann und über die Niederspannungsleitung (33) und die Niederspannungsanschlüsse (23) eine Niederspannung oberhalb der Kleinspannung und bis zu 1000 Volt Wechselspannung und/oder 1500 Volt Gleichspannung bereitgestellt werden kann, **dadurch gekennzeichnet, dass** das erste Anschlusselement (26) in zumindest einen dritten Bereich (201) und einen vierten Bereich (202) unterteilt ist, dass im dritten Bereich (201) dritte Steckkontakte (203) zum Übertragen von Daten und im vierten Bereich (202) vierte Stecckontakte (204) zum Übertragen von Kleinspannung angeordnet sind, dass erste Steckkontakte (171) eines Funktionsmoduls (100) mit den dritten Steckkontakten (203) verbunden werden können und dass zweite Stecckontakte (172) des Funktionsmoduls (100) mit den vierten Steckkontakten (204) verbunden werden können, dass die dritten Steckkontakte (203) und die vierten Stecckontakte (204) unterschiedlich ausgestaltet sind, und dass die ersten Anschlusselemente (26) und die zweiten Anschlusselemente (27) beabstandet voneinander angeordnet sind.

## Claims

1. Switchgear cabinet system (1) comprising a base module (10) and a plurality of functional modules (100), wherein the base module (10) has a housing (11) with a housing side (12) and openings (14) in the housing side (12), first connection elements (26) and second connection elements (27), wherein the first connection elements (26) provide data connections (21) and extra-low-voltage connections (22), wherein the second connection elements (27) provide low-voltage connections (23), wherein the first connection elements (26) are arranged within the housing (11) in the region of openings (14), wherein the data connections (21) are connected to a data line (31), wherein the extra-low-voltage connections (22) are connected to an extra-low-voltage line (32), wherein the low-voltage connections (23) are connected to a low-voltage line (33), wherein an extra-low voltage of up to 50 volts AC and/or 120 volts DC can be provided via the extra-low-voltage line (32) and the extra-low-voltage connections (22) and a low voltage of above the extra-low voltage and up to 1000 volts AC and/or 1500 volts DC can be provided via the low-voltage line (33) and the low-voltage connections (23), wherein the functional modules (100) each have a module housing (110), an electronic circuit (120) and a module connection element (130), wherein the module connection element (130) is connected to the electronic circuit (120), wherein the module housing (110) has a module housing side (111), wherein the module housing side (111) has a module housing opening (114), wherein the module connection element (130) comprises a first plug-in element (131), wherein the first plug-in element (131) extends through the module housing opening (114) from the interior of the module housing (110) to the exterior of the module housing (110) and is designed to engage into the first connection elements (26) of the base module (10), wherein, for at least one functional module (100), the module connection element (130) comprises a second plug-in element (132), wherein the second plug-in element (132) is designed to engage into the second connection elements (27) of the base module (10), **characterized in that** the first plug-in element (131) is subdivided at least into a first region (168) and a second region (169), **in that** first plug-in contacts (171) for transmitting data are arranged in the first region (168) and **in that** second plug-in contacts (172) for transmitting extra-low voltage are arranged in the second region (169), **in that** the first connection element (26) is subdivided into at least a third region (201) and a fourth region (202), **in that** third plug-in contacts (203) for transmitting data are arranged in the third region (201) and fourth plug-in contacts (204) for transmitting extra-low-voltage are arranged in the fourth region (202), **in that** the first plug-in contacts (171) can be connected to the third plug-in contacts (203) and **in that** the second plug-in contacts (172) can be connected to the fourth plug-in contacts (204), **in that** the first plug-in contacts (171) and the second plug-in contacts (172) are configured differently, and **in that** the first connection elements (26) and the second connection elements (27) are arranged in a manner spaced apart from one another.

2. Switchgear cabinet system (1) according to Claim 1, wherein the second connection elements (27) are arranged in the interior of the housing (11) and wherein the second plug-in element (132) extends through the module housing opening (114) from the interior of the module housing (110) to the exterior of the module housing (110).

3. Switchgear cabinet system (1) according to either of Claims 1 and 2, wherein the first plug-in contacts (171) and, respectively, the third plug-in contacts (203) comprise at least a first communication voltage contact (175), a second communication voltage contact (176), a first data connection element (181), a second data connection element (182), a third data connection element (183), a fourth data connection element (184), a fifth data connection element (185) and a sixth data connection element (186).

4. Switchgear cabinet system according to one of Claims 1 to 3, wherein the second plug-in contacts (172) and, respectively, the fourth plug-in contacts (204) comprise at least a first DC voltage contact (191), a second DC voltage contact (192), a third DC voltage contact (193), a fourth DC voltage contact (194), a fifth DC voltage contact (195), a sixth DC voltage contact (196) and a protective conductor contact (197).

5. Switchgear cabinet system (1) according to one of Claims 1 to 4, wherein the switchgear cabinet system (1) is configured to be liquid- and dust-tight.

6. Functional module (100) comprising a module housing (110), an electronic circuit (120) and a module connection element (130), wherein the module connection element (130) is connected to the electronic circuit (120), wherein the module housing (110) has a module housing side (111), wherein the module housing side (111) has a module housing opening (114), wherein the module connection element (130) comprises a first plug-in element (131), wherein the first plug-in element (131) extends through the module housing opening (114) from the interior of the module housing (110) to the exterior of the module housing (110) and is designed to engage into a first connection element (26) of a base module (10), wherein the module connection element (130) comprises a second plug-in element (132), wherein the second plug-in element (132) is designed to engage into the second connection elements (27) of the base module (10), **characterized in that** the first plug-in element (131) is subdivided at least into a first region (168) and a second region (169), **in that** first plug-in contacts (171) for transmitting data are arranged in the first region (168) and **in that** second plug-in contacts (172) for transmitting extra-low voltage are arranged in the second region (169), **in that** the first plug-in contacts (171) can be connected to third plug-in contacts (203) of the first connection element (26) of the base module (10) and **in that** the second plug-in contacts (172) can be connected to fourth plug-in contacts (204) of the first connection element (26) of the base module (10), **in that** the first plug-in contacts (171) and the second plug-in contacts (172) are configured differently, and **in that** the first plug-in element (131) and the second plug-in element (132) are arranged in a manner spaced apart from one another.

7. Functional module (100) according to Claim 6, wherein the second plug-in element (132) extends through the module housing opening (114) from the interior of the module housing (110) to the exterior of the module housing (110).

8. Functional module (100) according to either of Claims 6 and 7, wherein the module housing (110) contains a metal, in particular consists of a metal, wherein the metal contains, in particular, aluminium and/or zinc.

9. Functional module (100) according to one of Claims 6 to 8, wherein the module housing (110) consists of an extruded profile or is a die-cast housing.

10. Functional module (100) according to one of Claims 6 to 9, further having a fuse (160), wherein the fuse (160) is arranged between the module connection element (130) and the electronic circuit (120).

11. Base module (10) for a switchgear cabinet system (1), wherein the base module (10) has a housing (11) with a housing side (12) and openings (14) in the housing side (12), first connection elements (26) and second connection elements (27), wherein the first connection elements (26) provide data connections (21) and extra-low-voltage connections (22), wherein the second connection elements (27) provide low-voltage connections (23), wherein the first connection elements (26) are arranged within the housing (11) in the region of openings (14), wherein the data connections (21) are connected to a data line (31), wherein the extra-low-voltage connections (22) are connected to an extra-low-voltage line (32), wherein the low-voltage connections (23) are connected to a low-voltage line (33), wherein an extra-low voltage of up to 50 volts AC and/or 120 volts DC can be provided via the extra-low-voltage line (32) and the extra-low-voltage connections (22) and a low voltage above the extra-low voltage and up to 1000 volts AC and/or 1500 volts DC can be provided via the low-voltage line (33) and the low-voltage connections (23), **characterized in that** the first connection element (26) is subdivided into at least a third region (201) and a fourth region (202), **in that** third plug-in contacts (203) for transmitting data are arranged in the third region (201) and **in that** fourth plug-in contacts (204) for transmitting extra-low voltage are arranged in the fourth region (202), **in that** first plug-in contacts (171) of a functional module (100) can be connected to the third plug-in contacts (203) and **in that** second plug-in contacts (172) of the functional module (100) can be connected to the fourth plug-in contacts (204), **in that** the third plug-in contacts (203) and the fourth plug-in contacts (204) are configured differently, and **in that** the first connection elements (26) and the second connection elements (27) are arranged in a manner spaced apart from one another.

## Revendications

1. Système d'armoire de distribution (1) composé d'un module de base (10) et de plusieurs modules fonctionnels (100), le module de base (10) possédant un boîtier (11) comprenant un côté de boîtier (12) et des ouvertures (14) du côté de boîtier (12), des premiers éléments de raccordement (26) et des deuxièmes éléments de raccordement (27), les premiers éléments de raccordement (26) mettant à disposition des branchements de données (21) et des branchements de très basse tension (22), les deuxièmes éléments de raccordement (27) mettant à disposition des branchements de basse tension (23), les premiers éléments de raccordement (26) étant disposés à l'intérieur du boîtier (11) dans la zone des ouvertures (14), les branchements de données (21) étant connectés à une ligne de données (31), les branchements de très basse tension (22) étant connectés à une ligne de très basse tension (32), les branchements de basse tension (23) étant connectés à une ligne de basse tension (33), une très basse tension jusqu'à 50 volts de tension alternative et/ou 120 volt de tension continue pouvant être fournie par le biais de la ligne de très basse tension (32) et les branchements de très basse tension (22) et une basse tension, supérieure à la très basse tension, jusqu'à 1000 volts de tension alternative et/ou 1500 volts de tension continue pouvant être fournie par le biais de la ligne de basse tension (33) et les branchements de basse tension (23), les modules fonctionnels (100) possédant respectivement un boîtier de module (110), un circuit électronique (120) et un élément de raccordement de module (130), l'élément de raccordement de module (130) étant relié au circuit électronique (120), le boîtier de module (110) possédant un côté de boîtier de module (111), le côté de boîtier de module (111) possédant une ouverture de boîtier de module (114), l'élément de raccordement de module (130) possédant un premier élément à enfichage (131), le premier élément à enfichage (131) s'étendant à travers l'ouverture de boîtier de module (114) de l'intérieur du boîtier de module (110) vers l'extérieur du boîtier de module (110) et étant conçu pour venir en prise dans les premiers éléments de raccordement (26) du module de base (10), sur au moins un module fonctionnel (100), l'élément de raccordement de module (130) comportant un deuxième élément à enfichage (132), le deuxième élément à enfichage (132) étant conçu pour venir en prise dans les deuxièmes éléments de raccordement (27) du module de base (10), **caractérisé en ce que** le premier élément à enfichage (131) est subdivisé au moins en une première zone (168) et une deuxième zone (169), **en ce que** des premiers contacts à enfichage (171) destinés à la transmission de données sont disposés dans la première zone (168) et **en ce que** des deuxièmes contacts à enfichage (172) destinés à la transmission de la très basse tension sont disposés dans la deuxième zone (169), **en ce que** le premier élément de raccordement (26) est subdivisé au moins en une troisième zone (201) et une quatrième zone (202), **en ce que** dans la troisième zone (201) sont disposés des troisièmes contacts à enfichage (203) destinés à la transmission de données et dans la quatrième zone (202) des quatrièmes contacts à enfichage (204) destinés à la transmission de la très basse tension, **en ce que** les premiers contacts à enfichage (171) peuvent être connectés aux troisièmes contacts à enfichage (203) et **en ce que** les deuxièmes contacts à enfichage (172) peuvent être connectés aux quatrièmes contacts à enfichage (204), **en ce que** les premiers contacts à enfichage (171) et les deuxièmes contacts à enfichage (172) sont de configuration différente, et **en ce que** les premiers éléments de raccordement (26) et les deuxièmes éléments de raccordement (27) sont disposés espacés les uns des autres.

2. Système d'armoire de distribution (1) selon la revendication 1, les deuxièmes éléments de raccordement (27) étant disposés à l'intérieur du boîtier (11) et le deuxième élément à enfichage (132) s'étendant à travers l'ouverture de boîtier de module (114) de l'intérieur du boîtier de module (110) vers l'extérieur du boîtier de module (110).

3. Système d'armoire de distribution (1) selon l'une des revendications 1 ou 2, les premiers contacts à enfichage (171) ou les troisièmes contacts à enfichage (203) comportant au moins un premier contact de tension de communication (175), un deuxième contact de tension de communication (176), un premier élément de raccordement de données (181), un deuxième élément de raccordement de données (182), un troisième élément de raccordement de données (183), un quatrième élément de raccordement de données (184), un cinquième élément de raccordement de données (185) et un sixième élément de raccordement de données (186).

4. Système d'armoire de distribution selon l'une des revendications 1 à 3, les deuxièmes contacts à enfichage (172) ou les quatrièmes contacts à enfichage (204) comportant au moins un premier contact de tension continue (191), un deuxième contact de tension continue (192), un troisième contact de tension continue (193), un quatrième contact de tension continue (194), un cinquième contact de tension continue (195), un sixième contact de tension continue (196) ainsi qu'un contact de conducteur de protection (197).

5. Système d'armoire de distribution (1) selon l'une des revendications 1 à 4, le système d'armoire de distribution (1) étant réalisé étanche aux liquides et hermétique à la poussière.

6. Module fonctionnel (100) comprenant un boîtier de module (110), un circuit électronique (120) et un élément de raccordement de module (130), l'élément de raccordement de module (130) étant connecté au circuit électronique (120), le boîtier de module (110) possédant un côté de boîtier de module (111), le côté de boîtier de module (111) possédant une ouverture de boîtier de module (114), l'élément de raccordement de module (130) comportant un premier élément à enfichage (131), le premier élément à enfichage (131) s'étendant à travers l'ouverture de boîtier de module (114) de l'intérieur du boîtier de module (110) vers l'extérieur du boîtier de module (110) et étant conçu pour venir en prise dans un premier élément de raccordement (26) d'un module de base (10), l'élément de raccordement de module (130) comportant un deuxième élément à enfichage (132), le deuxième élément à enfichage (132) étant conçu pour venir en prise dans les deuxièmes éléments de raccordement (27) du module de base (10), **caractérisé en ce que** le premier élément à enfichage (131) est subdivisé au moins en une première zone (168) et une deuxième zone (169), **en ce que** des premiers contacts à enfichage (171) destinés à la transmission de données sont disposés dans la première zone (168) et **en ce que** des deuxièmes contacts à enfichage (172) destinés à la transmission de la très basse tension sont disposés dans la deuxième zone (169), **en ce que** les premiers contacts à enfichage (171) peuvent être connectés à des troisièmes contacts à enfichage (203) du premier élément de raccordement (26) du module de base (10) et **en ce que** les deuxièmes contacts à enfichage (172) peuvent être connectés à des quatrièmes contacts à enfichage (204) du premier élément de raccordement (26) du module de base (10), **en ce que** les premiers contacts à enfichage (171) et les deuxièmes contacts à enfichage (172) sont de configuration différente, et **en ce que** le premier élément à enfichage (131) et le deuxième élément à enfichage (132) sont disposés espacés l'un de l'autre.

7. Module fonctionnel (100) selon la revendication 6, le deuxième élément à enfichage (132) s'étendant à travers l'ouverture de boîtier de module (114) de l'intérieur du boîtier de module (110) vers l'extérieur du boîtier de module (110).

8. Module fonctionnel (100) selon l'une des revendications 6 ou 7, le boîtier de module (110) présentant un métal, notamment se composant de métal, le métal présentant de l'aluminium et/ou du zinc.

9. Module fonctionnel (100) selon l'une des revendications 6 à 8, le boîtier de module (110) se composant d'un profilé extrudé et étant un boîtier moulé sous pression.

10. Module fonctionnel (100) selon l'une des revendications 6 à 9, possédant en outre un dispositif de sécurité (160), le dispositif de sécurité (160) étant disposé entre l'élément de raccordement de module (130) et le circuit électronique (120).

11. Module de base (10) pour un système d'armoire de distribution (1), le module de base (10) possédant un boîtier (11) comprenant un côté de boîtier (12) et des ouvertures (14) du côté de boîtier (12), des premiers éléments de raccordement (26) et des deuxièmes éléments de raccordement (27), les premiers éléments de raccordement (26) mettant à disposition des branchements de données (21) des branchements de très basse tension (22), les deuxièmes éléments de raccordement (27) mettant à disposition des branchements de basse tension (23), les premiers éléments de raccordement (26) étant disposés à l'intérieur du boîtier (11) dans la zone des ouvertures (14), les branchements de données (21) étant connectés à une ligne de données (31), les branchements de très basse tension (22) étant connectés à une ligne de très basse tension (32), les branchements de basse tension (23) étant connectés à une ligne de basse tension (33), une très basse tension jusqu'à 50 volts de tension alternative et/ou 120 volts de tension continue pouvant être fournie par le biais de la ligne de très basse tension (32) et les branchements de très basse tension (22) et une basse tension, supérieure à la très basse tension, jusqu'à 1000 volts de tension alternative et/ou 1500 volts de tension continue pouvant être fournie par le biais de la ligne de basse tension (33) et les branchements de basse tension (23), **caractérisé en ce que** le premier élément de raccordement (26) est subdivisé au moins en une troisième zone (201) et une quatrième zone (202), **en ce que** dans la troisième zone (201) sont disposés des troisièmes contacts à enfichage (203) destinés à la transmission de données et dans la quatrième zone (202) des quatrièmes contacts à enfichage (204) destinés à la transmission de la très basse tension, **en ce que** les premiers contacts à enfichage (171) d'un module fonctionnel (100) peuvent être connectés aux troisièmes contacts à enfichage (203) et **en ce que** les deuxièmes contacts à enfichage (172) du module fonctionnel (100) peuvent être connectés aux quatrièmes contacts à enfichage (204), **en ce que** les troisièmes contacts à enfichage (203) et les quatrièmes contacts à enfichage (204) sont de configuration différente, et **en ce que** les premiers éléments de raccordement (26) et les deuxièmes éléments de raccordement (27) sont disposés espacés les uns des autres.
